# EUROPÄISCHE PATENTSCHRIFT

(11) **EP 2 401 342 B1**
(45) Veröffentlichungstag und Bekanntmachung des Hinweises auf die Patenterteilung: **12.06.2013**
(21) Anmeldenummer: 10703006.6
(22) Anmeldetag: 01.02.2010
(51) Int. Cl.: C09K 11/59

(54) **MIT ZIRKONIUM UND HAFNIUM CO-DOTIERTE NITRIDOSILIKATE**
NITRIDOSILICATES CO-DOPED WITH ZIRCONIUM AND HAFNIUM
NITRIDOSILICATE CO-DOPÉ AU ZIRCONIUM ET À L'HAFNIUM

(30) Priorität: 27.02.2009 DE 102009010705
(43) Veröffentlichungstag der Anmeldung: 04.01.2012
(73) Patentinhaber: Merck Patent GmbH, 64293 Darmstadt (DE)
(72) Erfinder: WINKLER, Holger, 64291 Darmstadt (DE); PETRY, Ralf, 64347 Griesheim (DE); VOSGROENE, Tim, 64372 Ober-Ramstadt (DE); JUESTEL, Thomas, 58455 Witten (DE); UHLICH, Dominik, 48565 Steinfurt (DE); DUTCZAK, Danuta, 48565 Steinfurt (DE)
(86) Internationale Anmeldenummer: PCT/EP2010/000592
(87) Internationale Veröffentlichungsnummer: WO 2010/097157

(56) Entgegenhaltungen:
- WO-A1-2008/122332
- US-A1- 2006 001 352
- US-A1- 2007 040 502
- US-A1- 2008 274 029
- LI Y Q ET AL: "Luminescence properties of Ce<3+>-activated alkaline earth silicon nitride M2Si5N8 (M=Ca, Sr, Ba) materials" JOURNAL OF LUMINESCENCE, AMSTERDAM, NL LNKD- DOI:10.1016/J.JLUMIN.2005.03.014, Bd. 116, Nr. 1-2, 1. Januar 2006 (2006-01-01), Seiten 107-116, XP025185796 ISSN: 0022-2313 [gefunden am 2006-01-01]

## Beschreibung

Die Erfindung betrifft Verbindungen, die aus mit Hf⁴⁺, Zr⁴⁺-, Li⁺, Na⁺ und/oder K⁺ -co-dotierten 2-5-8-Erdalkali-siliconitriden mit Eu- und/oder Ce-Aktivierung bestehen, deren Herstellung sowie deren Verwendung als Leuchtstoffe sowie LED-Konversionsleuchtstoffe für warm-weiße LEDs oder sogenannte Color-on-demand-Anwendungen.

Unter dem Color-on-demand Konzept versteht man die Realisierung von Licht eines bestimmten Farbpunktes mit einer pcLED (=phosphor converted LED) unter Einsatz eines oder mehrer Leuchtstoffe. Dieses Konzept wird z.B. verwendet, um bestimmte Corporate Designs z.B. für beleuchtete Firmenlogos, Marken etc. zu erzeugen.

Leuchtstoff-konvertierte LEDs stellen eine bedeutende Lichttechnologie dar, deren Innovationspotential zur zunehmenden Substitution von traditionellen künstlichen Lichtquellen (Glühfadenlampen, Entladungslampen etc.) führt.

Während die Halbleitertechnologie für LED nahezu ausgereizt ist, bieten die eingesetzten Leuchtstoffe Raum für Verbesserungen. Bei den LED-Herstellern wird die Notwendigkeit von roten Leuchtstoffen für (power) LEDs immer wieder betont. Erforderliche Eigenschaften roter Leuchtstoffe für den effizienten und effektiven Einsatz in der LED sind u. a.: Emissionsbanden in einem Wellenlängenbereich von 610 - 620 nm (Allgemeinbeleuchtung mit hohem CRI bzw. hoher CCT), bzw. 630 nm und 650 nm (Hintergrundbeleuchtung für LC-Displays mit großem Farbraum). Hohe Fluoreszenzlöschtemperaturen (TQ₅₀ >> 150 °C) Hohe chemische Stabilität gegenüber Säuren und Feuchtigkeit Hohe Lichtausbeute, welche aus hoher Absorption im Spektralbereich der Emissionsbande der anregenden LED, hoher Emissionslichtextraktion aus dem Leuchtstoff an die Umgebung und hoher Konversionseffizienz (QE) resultiert.

Es gibt eine Reihe an Leuchtstoffmaterialsystemen, welche einige, aber nicht sämtliche der o.g. vom LED-Hersteller geforderten Bedingungen erfüllen. Jedoch erst die Erfüllung sämtlicher Bedingungen wird den Austausch von traditionellen elektrischen Lichtquellen durch LEDs stark beschleunigen und zu einer Verringerung der weltweit benötigten elektrischen Energie für Beleuchtung führen.

Kommerziell erhältliche Leuchtstoffmaterialien, welche im Roten fluoreszieren und mit blauen (oder UV-LEDs) prinzipiell kombiniert werden können, sind vor allem:

### Ortho-Silikate:

Die Materialien weisen eine hohe Helligkeit und Effizienz auf, aber die längste Emissionswellenlänge liegt jedoch bei ca. 610 nm.

### Sulfite, Thiogallate und Sulfoselenide:

Diese Leuchtstoffe sind in der Lage in den o. a. Wellenlängenbereichen zu emittieren. Der größte Nachteil der schwefelhaltigen Materialien ist deren Instabilität gegen Luftsauerstoff und Feuchtigkeit. Beides gelangt in der LED über Diffusion durch das Silikon Bindermaterial sehr leicht an den Leuchtstoff und reagiert mit diesem, wobei er abgebaut wird. Zudem sind häufig nur geringe Dotierungsgrade möglich, wodurch es bei einer hohen Anregungsdichte zu Sättigungsphänomenen kommt.

### Nitride und Oxynitride

Kovalente Nitride können prinzipiell als Matrix für Leuchtstoffe eingesetzt werden, weil sie über eine große Bandlücke verfügen, in der die HOMO und LUMO von Aktivatorionen lokalisiert sind. Durch die hohe Kovalenz verursacht, weisen Nitride einen großen nephelxauletischen Effekt auf, wodurch die Energie der niedrigsten Kristallfeldkomponente der angeregten 4f5d-Konfiguration von Seltenerd-Aktivatoren, z. B. Eu²⁺, Ce³⁺ verringert wird. Dies führt zu einer langwelligen Anregung und Emission von Nitridleuchtstoffen (siehe Krevel et al., J. Alloys Compd. 1998,268,272) Insbesondere Siliconitride zeigen eine enge Verwandschaft zu Oxosiliziumverbindungen auf, da beide Systeme aus SiX₄ Tetraedern aufgebaut sind (X = O, N). Aufgrund des höheren Kondensationsgrades weisen Silikonitride allerdings eine höhere chemische Stabilität als Oxosiliziumverbindungen auf (siehe Xie et al, Sci.Tech. Adv. Mater. 2007,8, 588)

Insbesondere eignen sich Siliconitride zur Dotierung mit Aktivatorionen, wie Eu²⁺ und Ce³⁺, in denen mindestens ein Elektron im angeregten Zustand nicht von der Wirkung des Kristallfeldes (5s und 5d) abgeschirmt werden. Solche Aktivatoren weisen spektroskopische Eigenschaften auf, die sehr stark von der Umgebung (Symmetrie, Kovalenz, Koordination, Feldstärke, Bindungslängen, Gitterplatzgröße) abhängen. Die hohe Formalladung von Stickstoff (N³⁻) führt im Gegensatz zur niedrigeren Formalladung von Sauerstoff (O²⁻) dazu, dass o. a. Aktivatoren in Siliconitriden eine größere Kristallfeldaufspaltung der 5d Orbitale erfahren und der energetische Schwerpunkt der 5d Orbitale zu geringeren Energie verschoben wird als es in analogen Si-O-Materialien der Fall ist. Dadurch zeigen die Anregungs- und Emissionsbanden des Aktivators eine spektrale Rotverschiebung. Des Weiteren führt das stabilere und starrere Gitter der Siliconitride im Gegensatz zu dem der Oxosiliziumverbindungen dazu, dass der Stokes-Shift verringert wird, wodurch die thermische Löschung erst bei höheren Temperaturen stattfindet und die Konversionseffizienz erhöht wird.

Als erstes Leuchtstoffsystem der Siliconitride wurde das CaSiN₂.Eu²⁺ veröffentlicht (siehe Lim et a. SPIE Vol. 3241, 1997, Photoluminescence of CaSiN₂:Eu). Dieser Leuchtstoff eignet sich als Konverter für blau und UVemittierende LEDs, weil er bei Anregung in diesen Wellenlängenbereichen Lumineszenz bei ca. 630 nm zeigt.

In EP 1153101 und EP 1238041 werden sogenannte "2-5-8"-Siliconitride der Zusammensetzung (Ca,Sr,Ba)₂₋ₓSi₅N₈:Euₓ beschrieben. Diese Leuchtstoffe können vom nahen UV bis in den blauen Spektralbereich angeregt werden und emittieren je nach der chemischen Zusammensetzung von orange bis tiefrot.

Aus US 2007/040502 A1 sind Calcium-siliconitride bekannt, welche mit Cer, Natrium und teilweise Europium dotiert sind. Es sind jedoch keine Verbindungen offenbart, welche mit Zirkonium und/oder Hafnium dotiert sind.

Li et al. (Journal of Luminescence 2006, 116 (1-2), 107-116) offenbaren Calcium-, Strontium- und Barium-siliconitride, welche mit Cer und Natrium oder Lithium dotiert sind. Li et al. offenbaren jedoch keine Verbindungen, welche mit Zirkonium und/oder Hafnium dotiert sind.

Aufgabe der vorliegenden Erfindung ist es daher die o.g. 2-5-8-Erdalkali-Siliconitride so zu modifizieren, dass diese Verbindungen eine noch höhere Lichteffizienz erreichen.

Überraschenderweise wurde gefunden, dass die Anforderung nach einer wirtschaftlich bedeutenden weiteren Steigerung der Konversionseffizienz der Leuchtstoffe (Ca,Sr,Ba)₂₋ₓSi₅Nₐ:Euₓ erfüllt werden kann, falls eine Co-Dotierung mit vierwertigen und/oder einwertigen Kationen durchgeführt wird.

Gegenstand der vorliegenden Erfindung sind somit Verbindungen des 2-5-8-Erdalkali-siliconitridtyps der Formel M₂Si₅N₈:Eu²⁺ mit optionaler Cer-Dotierung, wobei M für ein Erdalkalimetall oder eine Mischung aus mehreren Erdalkalimetallen steht, die zusätzlich mindestens einen Co-Dotanden enthalten, ausgewählt aus der Gruppe bestehend aus Hafnium, Zirkonium, Lithium, Natrium und, wobei mindestens ein Co-Dotand ausgewählt ist aus der Gruppe bestehend aus Hafnium und Zirkonium.

Unter "2-5-8-Erdalkali-siliconitriden" (auch "2-5-8-Nitride oder "2-5-8-Erdalkali-nitridosilikate genannt) versteht man solche Zusammensetzungen M₂Si₅N₈:Eu²⁺, wobei M ein Erdalkalimetall oder eine Mischung aus mehreren Erdalkalimetallen darstellt.

Bevorzugt sind Verbindungen der Formel I

Ma_{2-y} (Ca,Sr,Ba)_{1-x-y}Si_{5-z}Me_{z}N₈:EuₓCe_{y} (I)

wobei
Ma = Li, Na und/oder K
Me = Hf⁴⁺ und/oder Zr⁴⁺"
x = 0.0015 bis 0.20
y = 0 bis 0.15
und
z< 4
ist.

Bevorzugt ist es, wenn der z-Wert (der für die Atomkonzentration der Co-Dotanten Me steht) < 1, noch bevorzugter < 0.1, am bevorzugtesten gleich 0.0002 bis 0.02 beträgt. Bevorzugt ist x = 0.005 bis 0.19 und y = 0 bis 0.08.

Die größere Helligkeit der erfindungsgemäßen Verbindungen bzw. Leuchtstoffe gemäß den Formeln I gegenüber denjenigen identischer Zusammensetzung, aber ohne die Co-Dotanden Hf und/oder Zr lässt sich mit den dem Fachmann bekannten Theorien dadurch erklären, dass diese Ionen einen Einfluss auf die Lebensdauer der angeregten Zustände der Aktivatorionen aufweisen: Angeregte Elektronen solcher Leuchtstoffe kehren nach kürzerer Zeit unter Aussendung des Fluoreszenzlichtes wieder in den Grundzustand zurück. D.h. diese Elektronen können in demselben Zeitintervall mehr Anregungs- und Relaxatationsprozesse durchführen. (s. S. Shionoya, W. M. Yen, Phosphor Handbook, CRC Press, New York, 1999, ISBN 0-8493-7560-6).

Dem Fachmann ist bekannt, dass die Coaktivierung von Eu²⁺-Leuchtstoffen mit Ce³⁺ zu günstigen Eigenschaften des Eu²⁺-Leuchtstoffes führen kann, wodurch der Leuchtstoff effizienter oder stabiler gestaltet werden kann.

Des Weiteren können diese Co-Dotanden dadurch effizienzsteigernd wirken, indem sie im Siliconitrid vorhandenen, unerwünschten Sauerstoff (welcher zu einer Einbuße an Helligkeit bzw. Effizienz und Verschiebung der Farbpunkte führt) binden können.

Die Partikelgröße der erfindungsgemäßen Verbindungen beträgt zwischen 50 nm und 30 µm, vorzugsweise zwischen 1 µm und 20 µm, noch bevorzugter zwischen 2 und 15 µm,

Vorzugsweise können in dem Kristallgitter der erfindungemäßen Verbindungen noch einwertige Ionen wie Li, Na und/oder K und Halogenide wie F oder Cl eingebaut sein. Diese einwertigen Ionen werden vorzugsweise als Flussmittel bei der Leuchtstoffherstellung eingesetzt und dienen zur Erhöhung der Kristallqualität, Grobeinstellung der Partikelgröße und der Partikelmorphologie und besitzen dadurch ein hohes Potential zur Effizienzsteigerung der Leuchtstoffe. Diese Vorgehensweise ist dem Fachmann bekannt (siehe z.B. H.S. Kang et al. Mater. Science and Engineering B 121 (2005) 81-85).

Des weiteren können in dem Kristallgitter der erfindungsgemäßen 2-5-8-Nitride Sauerstoff und Kohlenstoff mit einem Gehalt von < 0.2 at-% enthalten sein. Es ist bekannt, das diese Substanzen durch Verwendung von Flussmitteln bzw. aus den Edukten als Bestandteile der Nitride in Frage kommen (siehe Hintzen et al, Chem. Mater. 2005, 17, 3242-48 "Synthese von Me2Si5N8:Eu aus Me-Carbonaten" oder X. Piao et al, Applied Physis Lett. 88, 161908(2006) "Characterization and luminescence properties of Sr2Si5N8:Eu2+ phosphor for white light-emitting-diode illumination*"* oder R. Xie et al. Chem. Mater. 2006, 18 (23), 5578-5583 "A simple, efficient synthetic route to SrSiN: Eu-based red Phosphors for white LED")

Denkbar ist auch, dass die 2-5-8 Nitride mit Mn, Mg, Be, Ni, Co, Th und/oder Ru co-dotiert sind, wobei hier zusätzlich noch F, O oder C im Kristallgitter eingebaut sein können.

Ein weiterer Gegenstand der vorliegenden Erfindung ist eine erfindungsgemäße Verbindung erhältlich durch Mischen von Siliciumnitrid-, Europium-, Cer- und Calcium- und/oder Strontium- und /oder Barium-haltigen Edukten mit mindestens einem Co-Dotierstoff ausgewählt aus der Gruppe bestehend aus Hafnium-, Zirkonium-, Lithium-, Natrium- und Kalium-haltigen Co-Dotierstoffen nach Festkörperdiffusionsmethoden und anschließender thermischer Nachbehandlung.

Ein weiterer Gegenstand der vorliegenden Erfindung ist ein Verfahren zur Herstellung einer erfindungsgemäßen Verbindung mit folgenden Verfahrensschritten:
- Herstellen einer Eu-und/oder Ce-dotierten 2-5-8-Erdalkali-siliconitrid-Verbindung, die mit mindestens einem Material ausgewählt aus der Gruppe bestehend aus Hafnium-, Zirkonium-, Lithium, Natrium und Kalium-haltigen Materialien co-dotiert wird, durch Mischen von mindestens 4 Edukten ausgewählt aus Siliciumnitrid-, Europium-, Cer-, Calcium-, Strontium-, Barium-, Hafnium-, Zirkonium-, Lithium-, Natrium-, Kalium-haltigen Materialien,
- Thermische Nachbehandlung der mit Hf- und/oder Zr-co-dotierten Verbindung.

Die Edukte zur Herstellung der Verbindung bestehen, wie oben erwähnt, aus Siliciumnitrid (Si₃N₄), Calciumhydrid, Europiumfluorid und/oder Cerfluorid sowie mindestens einem Hf-, Zr-, Li-, Na- und/oder K-haltigen Co-Dotierstoff. Als Edukte kommen neben den bevorzugten Nitriden, Hydriden und Fluoriden auch weitere anorganische und/oder organische Stoffe wie Cyanamide, Dicyanamide, Cyanide, Oxalate, Malonate, Fumarate, Carbonate, Citrate, Ascorbate und Acetylacetonate in Frage.

Die oben genannte thermische Nachbehandlung (siehe Verfahrensschritt b) verläuft mehrere Stunden unter reduzierenden Bedingungen, z. B mit Formiergas (z.B.90/10), reinem Wasserstoff und/oder in Ammoniak-Atmosphäre und/oder Stickstoff bzw. Mischungen aus Methan und Stickstoff mit oder ohne den oben aufgeführten Atmosphären, wobei diese Behandlung auch bei erhöhten Drücken stattfinden kann. Die Temperaturen beim Glühprozess betragen zwischen 1000°C und 1800°C, vorzugsweise von 1200°C bis 1650°C.

Mit Hilfe der o.g. Verfahren können beliebige äußere Formen der erfindungsgemäßen Verbindungen bzw. Leuchtstoffe, hergestellt werden, wie sphärische Partikel, Plättchen und strukturierte Materialien und Keramiken. Diese Formen werden erfindungsgemäß unter dem Begriff "Formkörper" zusammengefasst. Vorzugsweise handelt es sich bei dem Formkörper um einen "Leuchtstoffkörper".

Ein weiterer Gegenstand der vorliegenden Erfindung ist somit ein Formkörper enthaltend die erfindungsgemäßen Verbindungen, wobei er eine raue Oberfläche besitzt, die Nanopartikel aus SiO₂, TiO₂, Al₂O₃, ZnO, ZrO₂ und/oder Y₂O₃ oder Mischoxide daraus und/oder Partikel mit der erfindungsgemäßen Verbindung mit oder ohne Dotierstoffen aus der Reihe Europium, Cer,Hafnium, Zirkonium, Lithium, Natrium und/oder Kalium.

In einer weiteren bevorzugten Ausführungsform besitzt der Formkörper auf der, einem LED Chip entgegengesetzten Seite eine strukturierte (z.B. pyramidale) Oberfläche (siehe WO2008/058619, Merck, die voll umfänglich in den Kontext der vorliegenden Anmeldung durch Bezugnahme eingefügt wird). Somit kann möglichst viel Licht aus dem Leuchtstoff ausgekoppelt werden.

Die strukturierte Oberfläche auf dem Formkörper wird durch nachträgliches Beschichten mit einem geeigneten Material, welches bereits strukturiert ist, oder in einem nachfolgenden Schritt durch (photo-) lithografische Verfahren, Ätzverfahren oder durch Schreibverfahren mit Energie- oder Materiestrahlen oder Einwirkung von mechanischen Kräften hergestellt.

In einer weiteren bevorzugten Ausführungsform besitzen die erfindungsgemäßen Formkörper auf der, einem LED Chip entgegengesetzten Seite eine raue Oberfläche, die Nanopartikel aus SiO₂, TiO₂, Al₂O₃, ZnO₂, ZrO₂ und/oder Y₂O₃ oder Kombinationen aus diesen Materialien und/oder aus Partikeln mit der Leuchtstoffzusammensetzung gemäß Formel I mit oder ohne Dotierstoffen aus der Reihe Mn, Mg, Be, Ni, Co, Th und/oder Ru trägt. Dabei hat eine raue Oberfläche eine Rauhigkeit von bis zu einigen 100 nm. Die beschichtete Oberfläche hat den Vorteil, dass interne Totalreflexion verringert oder verhindert werden kann und das Licht besser aus dem erfindungsgemäßen Leuchtstoff ausgekoppelt werden kann (siehe WO2008/058619 (Merck), die voll umfänglich in den Kontext der vorliegenden Anmeldung durch Bezugnahme eingefügt wird.)

Weiterhin bevorzugt ist es, wenn die erfindungsgemäßen Formkörper auf der dem Chip abgewandten Oberfläche eine Brechzahl angepasste Schicht besitzen, welche die Auskopplung der Primärstrahlung und oder der vom Leuchtstoffkörper emittierten Strahlung erleichtert.

In einer weiteren bevorzugten Ausführungsform besitzen die Formkörper eine geschlossene Oberflächenbeschichtung, die aus SiO₂, TiO₂, Al₂O₃, ZnO, ZrO₂ und/oder Y₂O₃ oder Mischoxide und/oder aus den Verbindungen gemäß Formel I ohne den Aktivator Europium und/oder Cer besteht. Diese Oberflächenbeschichtung hat den Vorteil, dass durch eine geeignete Abstufung der Brechungsindices der Beschichtungsmaterialien eine Anpassung des Brechungsindex mit der Umgebung erzielt werden kann. In diesem Fall wird die Streuung des Lichtes an der Oberfläche des Leuchtstoffes verringert und ein größerer Anteil des Lichtes kann in den Leuchtstoff eindringen und dort absorbiert und konvertiert werden. Außerdem ermöglicht es die Brechungsindex-angepasste Oberflächenbeschichtung, dass mehr Licht aus dem Leuchtstoff ausgekoppelt wird, weil die interne Totalreflexion verringert wird.

Zudem ist eine geschlossene Schicht dann vorteilhaft, wenn der Leuchtstoff verkapselt werden muss. Dies kann erforderlich sein, um einer Empfindlichkeit des Leuchtstoffes oder Teilen davon gegen diffundierendes Wasser oder andere Materialien in der unmittelbaren Umgebung zu entgegnen. Ein weiterer Grund für die Verkapselung mit einer geschlossenen Hülle ist eine thermische Entkoppelung des eigentlichen Leuchtstoffes von der Wärme, die im Chip entsteht. Diese Wärme führt zu einer Verringerung der Fluoreszenzlichtausbeute des Leuchtstoffes und kann auch die Farbe des Fluoreszenzlichts beeinflussen. Schließlich ist es möglich durch eine solche Beschichtung die Effizienz des Leuchtstoffes zu erhöhen, indem im Leuchtstoff entstehende Gitterschwingungen in ihrer Ausbreitung an die Umgebung gehindert werden.

Außerdem bevorzugt ist es, wenn der Formkörper eine poröse Oberflächenbeschichtung besitzt, die aus SiO₂, TiO₂, Al₂O₃, ZnO, ZrO₂ und/oder Y₂O₃ oder Mischoxide daraus und/oder aus den Verbindungen gemäß Formeln I mit oder ohne Dotierstoffen aus der Reihe Eu, Ce, Hf, Zr, Li, Na und/oder K besteht. Diese porösen Beschichtungen bieten die Möglichkeit, den Brechungsindex einer Einfachschicht weiter zu reduzieren. Die Herstellung solcher poröser Beschichtungen kann nach drei herkömmlichen Methoden geschehen, wie sie in WO 03/027015 beschrieben werden, die voll umfänglich in den Kontext der vorliegenden Anmeldung durch Bezugnahme eingefügt wird: das Ätzen von Glas (z.B. Natron-Kalk-Gläser (siehe US 4019884)), das Aufbringen einer porösen Schicht und die Kombination aus poröser Schicht und einem Ätzvorgang.

In einer weiteren bevorzugten Ausführungsform besitzt der Formkörper eine Oberfläche, die funktionelle Gruppen trägt, welche eine chemische oder physikalische Anbindung an die Umgebung, vorzugsweise bestehend aus Epoxy- oder Silikonharz ermöglicht. Diese funktionellen Gruppen können z.B. über Oxogruppen angebundene Ester oder andere Derivate sein, die mit Bestandteilen der Bindemittel auf Basis von Epoxiden und /oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff/ Bindemittel und auch die Topfzeiten in einem gewissen Masse eingestellt werden. Damit wird die Verarbeitung der Gemische vereinfacht. Von einer physikalischen Anbindung an die Umgebung spricht man in diesem Zusammenhang, wenn zwischen den Systemen elektrostatische Wechselwirkungen über Ladungsfluktuationen oder Partialladungen wirken.

Da die auf dem LED Chip aufgebrachte erfindungsgemäße Leuchtstoffschicht vorzugsweise aus einem Gemisch von Silikon und homogenen Leuchtstoffpartikeln besteht, und das Silikon eine Oberflächenspannung aufweist, ist diese Leuchtstoffschicht auf mikroskopischer Ebene nicht einheitlich bzw. ist die Dicke der Schicht nicht durchweg konstant.

Die Herstellung von plättchenförmigen Leuchtstoffen als weitere bevorzugte Ausführungsform geschieht nach herkömmlichen Verfahren aus den entsprechenden Metall- und/oder Seltenerd-Salzen. Das Herstellverfahren ist in EP 763573 und WO2008/058620 ausführlich beschrieben, welche voll umfänglich in den Kontext der vorliegenden Anmeldung durch Bezugnahme eingefügt werden. Diese plättchenförmigen Leuchtstoffe können hergestellt werden, indem ein natürlicher oder synthetisch hergestellter hoch stabiler Träger bzw. ein Substrat aus beispielsweise Glimmer-, SiO₂-, Al₂O₃-, ZrO₂ -, Glas- oder TiO₂-Plättchen, welches ein sehr großes Aspektverhältnis aufweist, eine atomar glatte Oberfläche und eine einstellbare Dicke besitzt, durch Fällungsreaktion in wässriger Dispersion oder Suspension mit einer Leuchtstoffschicht beschichtet werden kann. Neben Glimmer, ZrO₂, SiO₂, Al₂O₃, Glas oder TiO₂ oder Gemischen derselben können die Plättchen auch aus dem Leuchtstoffmaterial selbst bestehen, oder aus einem Material aufgebaut sein. Falls das Plättchen selbst lediglich als Träger für die Leuchtstoffbeschichtung dient, muss diese aus einem Material bestehen, welches transparent für die Primärstrahlung der LED ist, oder die Primärstrahlung absorbiert und diese Energie auf die Leuchtstoffschicht überträgt. Die plättchenförmigen Leuchtstoffe werden in einem Harz (z. B. Silikon- oder Epoxidharz), dispergiert und diese Dispersion wird auf dem LED Chip aufgebracht.

Die plättchenförmigen Leuchtstoffe können in Dicken von 50 nm bis zu etwa 20 µm, vorzugsweise zwischen 150 nm und 5 µm, grosstechnisch hergestellt werden. Der Durchmesser beträgt dabei von 50 nm bis 20 µm. Er besitzt in der Regel ein Aspektverhältnis (Verhältnis des Durchmessers zur Teilchendicke) von 1 : 1 bis 400 : 1, und insbesondere 3 : 1 bis 100 : 1. Die Plättchenausdehnung (Länge x Breite) ist von der Anordnung abhängig. Plättchen eignen sich auch als Streuzentren innerhalb der Konversionsschicht, insbesondere dann, wenn sie besonders kleine Abmessungen aufweisen.

Die dem LED Chip zugewandte Oberfläche des erfindungsgemäßen plättchenförmigen Leuchtstoffes kann mit einer Beschichtung versehen werden, welche entspiegelnd in Bezug auf die von dem LED Chip emittierte Primärstrahlung wirkt. Dies führt zu einer Verringerung der Rückstreuung der Primärstrahlung, wodurch diese besser in den erfindungsgemäßen Leuchtstoffkörper eingekoppelt werden kann.

Hierfür eignen sich beispielsweise brechzahl-angepasste Beschichtungen, die eine folgende Dicke d aufweisen müssen: d = [Wellenlänge der Primärstrahlung des LED Chips /(4* Brechzahl der Leuchtstoffkeramik)], s. beispielsweise Gerthsen, Physik, Springer Verlag, 18. Auflage, 1995. Diese Beschichtung kann auch aus photonischen Kristallen bestehen. Wobei hierunter auch eine Strukturierung der Oberfläche des plättchenförmigen Leuchtstoffes fällt, um bestimmte Funktionalitäten zu erreichen.

Die Herstellung der erfindungsgemäßen Formkörper in Form von keramischen Körpern erfolgt analog nach dem in der WO 2008/017353 (Merck) beschrieben Verfahren, die voll umfänglich in den Kontext der vorliegenden Anmeldung durch Bezugnahme eingefügt wird. Dabei wird der Leuchtstoff durch Mischen der entsprechenden Edukte und Dotierstoffe hergestellt, anschließend isostatisch verpresst und in Form eines homogenen dünnen und nicht porösen Plättchens direkt auf die Oberfläche des Chips aufgebracht oder in Abstand zum Chip (remote phosphor-Konzept). Die jeweilige Anordnung hängt u.a. von der Architektur des LED devices ab, wobei der Fachmann in der Lage ist, die vorteilhafte Anordnung auszuwählen. Somit findet keine ortsabhängige Variation der Anregung und Emission des Leuchtstoffes statt, wodurch die damit ausgerüstete LED einen homogenen und farbkonstanten Lichtkegel emittiert und über eine hohe Lichtleistung verfügt. Die keramischen Leuchtstoffkörper können z.B. als Plättchen in Dicken von einigen 100 nm bis zu etwa 500 µm großtechnisch hergestellt werden. Die Plättchenausdehnung (Länge x Bereite) ist von der Anordnung abhängig. Bei direkter Aufbringung auf den Chip ist die Größe des Plättchens gemäß der Chipausdehnung (von ca. 100 µm * 100 µm bis zu mehreren mm²) mit einem gewissen Übermaß von ca. 10% - zu 30% der Chipoberfläche bei geeigneter Chipanordnung (z.B. Flip-Chip-Anordnung) oder entsprechend zu wählen. Wird das Leuchtstoffplättchen über einer fertigen LED angebracht, so ist der austretende Lichtkegel vollständig vom Plättchen zu erfassen.

Die Seitenflächen des keramischen Leuchtstoffkörpers können mit einem Leicht- oder Edelmetall, vorzugsweise Aluminium oder Silber verspiegelt werden. Die Verspiegelung bewirkt, dass kein Licht lateral aus dem Leuchtstoffkörper austritt. Lateral austretendes Licht kann den aus der LED auszukoppelnden Lichtstrom verringern. Die Verspiegelung des keramischen Leuchtstoffkörpers erfolgt in einem Prozessschritt nach der isostatischen Verpressung zu Stangen oder Plättchen, wobei vor der Verspiegelung eventuell ein Schneider der Stangen oder Plättchen in die erforderliche Größe erfolgen kann. Die Seitenflächen werden hierzu z.B. mit einer Lösung aus Silbernitrat und Glucose benetzt und anschließend bei erhöhter Temperatur einer Ammoniak-Atmosphäre ausgesetzt. Hierbei bildet sich z.B. ein silberner Belag auf den Seitenflächen aus.

Alternativ bieten sich auch stromlose Metallisierungsverfahren an, siehe beispielsweise Hollemann-Wiberg, Lehrbuch der Anorganischen Chemie, Walter de Gruyter Verlag oder Ullmanns Enzyklopädie der chemischen Technologie.

Der keramische Leuchtstoffkörper kann, falls erforderlich, mit einer Wasserglaslösung auf dem Untergrund eines LED Chip fixiert werden.

In einer weiteren Ausführungsform besitzt der keramische Leuchtstoffkörper auf der, einem LED Chip entgegengesetzten Seite eine strukturierte (z.B. pyramidale) Oberfläche. Somit kann möglichst viel Licht aus dem Leuchtstoffkörper ausgekoppelt werden. Die strukturierte Oberfläche auf dem Leuchtstoffkörper wird dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Ein weiterer Gegenstand der vorliegenden Erfindung ist ein Verfahren zur Herstellung eines Formkörpers, vorzugsweise Leuchtstoffkörpers, mit folgenden Verfahrensschritten:
a) Herstellen einer Europium-dotierten 2-5-8-Erdalkali-siliconitrid-Verbindung, die mit Hafnium- und/oder Zirkonium-haltigen Materialien codotiert wird, durch Mischen von mindestens 4 Edukten ausgewählt aus Siliciumnitrid-, Europium-, Cer-, Calcium-, Strontium-, Barium-, Hafnium-Zirkonium-, Lithium-, Natrium- und/oder Kalium-haltigen Materialien,
b) Thermische Nachbehandlung der codotierten Verbindung und Entstehung eines Formkörpers mit rauer Oberfläche,
c) Beschichtung der rauen Oberfläche mit Nanopartikeln aus SiO₂ TiO₂, Al₂O₃, ZnO, ZrO₂ und/oder Y₂O₃ oder Mischoxide daraus oder mit Nanopartikeln aus den erfindungsgemäßen Verbindungen.

Die Anregbarkeit der erfindungsgemäßen Leuchtstoffe erstrecken sich zudem über einen weiten Bereich, der von etwa 250 nm bis 530 nm, bevorzugt 430 nm bis zu etwa 500 nm reicht. Damit sind diese Leuchtstoffe nicht nur zur Anregung durch UV oder blau emittierende Primärlichtquellen wie LEDs oder konventionelle Entladungslampen (z.B. auf Hg-Basis) geeignet, sondern auch für Lichtquellen wie solche, welche die blaue In³⁺ -Linie bei 451 nm ausnutzen.

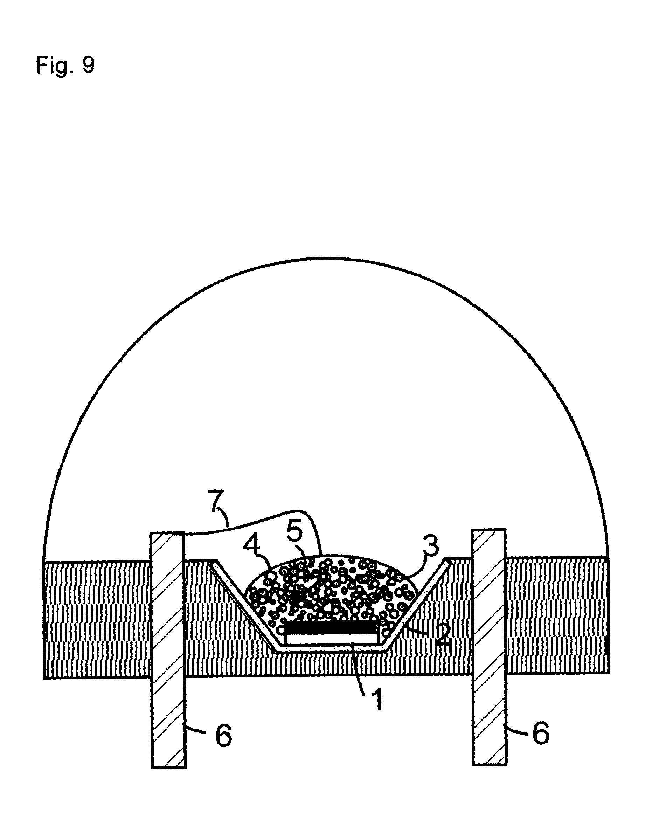

Ein weiterer Gegenstand der vorliegenden Erfindung ist eine Beleuchtungseinheit mit mindestens einer Primärlichtquelle, dessen Emissionsmaximum bzw. -maxima im Bereich 250 nm bis 530 nm, bevorzugt 430 nm bis zu etwa 500 nm reicht. Insbesondere bevorzugt ist ein Bereich zwischen 440 und 480 nm, wobei die primäre Strahlung teilweise oder vollständig durch die erfindungsgemäßen Verbindungen bzw. Leuchtstoffe in längerwellige Strahlung konvertiert wird. Vorzugsweise ist diese Beleuchtungseinheit weiß emittierend oder emittiert Licht mit einem bestimmten Farbpunkt (Color-on-demand-Prinzip). Bevorzugte Ausführungsformen der erfindungsgemäßen Beleuchtungseinheiten sind in den Figuren 9 bis 20 dargestellt.

In einer bevorzugten Ausführungsform der erfindungsgemäßen Beleuchtungseinheit handelt es sich bei der Lichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 ist.

Dem Fachmann sind mögliche Formen von derartigen Lichtquellen bekannt. Es kann sich hierbei um lichtemittierende LED-Chips unterschiedlichen Aufbaus handeln.

In einer weiteren bevorzugten Ausführungsform der erfindungsgemäßen Beleuchtungseinheit handelt es sich bei der Lichtquelle um eine lumineszente auf ZnO, TCO (Transparent conducting oxide), ZnSe oder SiC basierende Anordnung oder auch um eine organisch lichtemittierende Anordnung (OLED).

In einer weiteren bevorzugten Ausführungsform der erfindungsgemäßen Beleuchtungseinheit handelt es sich bei der Lichtquelle um eine Quelle, die Elektrolumineszenz und/oder Photolumineszenz zeigt. Weiterhin kann es sich bei der Lichtquelle auch um eine Plasma- oder Entladungsquelle handeln.

Die erfindungsgemäßen Leuchtstoffe können entweder in einem Harz dispergiert (z.B. Epoxy- oder Siliconharz), oder bei geeigneten Größenverhältnissen direkt auf der Primärlichtquelle angeordnet werden oder aber von dieser, je nach Anwendung, entfernt angeordnet sein (letztere Anordnung schließt auch die "Remote phosphor Technologie" mit ein). Die Vorteile der "Remote phosphor Technologie" sind dem Fachmann bekannt und z.B. der folgenden Publikation zu entnehmen: Japanese Journ. of Appl. Phys. Vol. 44, No. 21 (2005). L649-L651.

In einer weiteren Ausführungsform ist es bevorzugt, wenn die optische Ankopplung der Beleuchtungseinheit zwischen dem Leuchtstoff und der Primärlichtquelle durch eine lichtleitende Anordnung realisiert wird. Dadurch ist es möglich, dass an einem zentralen Ort die Primärlichtquelle installiert wird und diese mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem Lichtleiter, der an die Primärlichtquelle angekoppelt ist, realisieren. Auf diese Weise ist es möglich, eine starke Primärlichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Ein weiterer Gegenstand der vorliegenden Erfindung ist die Verwendung der erfindungsgemäßen Verbindungen und Formkörper als Leuchtstoff bzw. Leuchtstoffkörper.

Ein weiterer Gegenstand der vorliegenden Erfindung ist die Verwendung der erfindungsgemäßen Verbindungen zur teilweisen oder vollständigen Konversion der blauen oder im nahen UV-liegenden Emission einer Lumineszenzdiode.

Weiterhin bevorzugt ist die Verwendung der erfindungsgemäßen Verbindungen zur Konversion der blauen oder im nahen UV-liegenden Emission in sichtbare weiße Strahlung. Weiterhin ist die Verwendung der erfindungsgemäßen Verbindungen zur Konversion der Primärstrahlung in einen bestimmten Farbpunkt nach dem "Color on demand"- Konzept bevorzugt.

Die erfindungsgemäßen Verbindungen der Formel I können einzeln, oder als Mischung mit den dem Fachmann geläufigen folgenden Leuchtstoffen eingesetzt werden:
Ba₂SiO₄:Eu²⁺, BaSi₂O₅:Pb²⁺, BaₓSri₁₋ₓF₂:Eu²⁺, BaSrMgSi₂O₇:Eu²⁺, BaTiP₂O₇, (Ba,Ti)₂P₂O₇:Ti, Ba₃WO₆:U, BaY₂F₈ Er³⁺, Yb⁺, Be₂SiO₄:Mn²⁺, Bi₄Ge₃O₁₂, CaAl₂O₄:Ce³⁺, CaLa₄O₇:Ce³⁺, CaAl₂O₄:Eu²⁺, CaAl₂O₄:Mn²⁺, CaAl₄O₇:Pb²⁺,Mn²⁺, CaAl₂O₄:Tb³⁺, Ca₃Al₂Si₂O₁₂:Ce³⁺, Ca₃Al₂Si₃Oi₂:Ce³⁺, Ca₃Al₂Si₃O,₂:Eu²⁺, Ca₂B₅O₉Br:Eu²⁺, Ca₂B₅O₉Cl:Eu²⁺, Ca₂B₅O₉Cl:Pb²⁺, CaB₂O₄:Mn²⁺, Ca₂B₂O₅:Mn²⁺, CaB₂O₄:Pb²⁺, CaB₂P₂Cl₉:Eu²⁺, Ca₅B₂SiO₁₀:Eu³⁺, Ca_{0.5}Ba_{0.5}Al₁₂O₁₉:Ce³⁺,Mn²⁺, Ca₂Ba₃(PO4)₃Cl:Eu²⁺, CaBr₂:Eu²⁺ in SiO₂, CaCl₂:Eu²⁺ in SiO₂, CaCl₂:Eu²⁺,Mn²⁺ in SiO₂, CaF₂:Ce³⁺, CaF₂:Ce³⁺,Mn²⁺, CaF₂:Ce³⁺,Tb³⁺, CaF₂:Eu²⁺, CaF₂:Mn²⁺, CaF₂:U, CaGa₂O₄:Mn²⁺, CaGa₄O₇:Mn²⁺, CaGa₂S₄:Ce³⁺, CaGa₂S₄:Eu²⁺, CaGa₂S₄:Mn²⁺, CaGa₂S₄:Pb²⁺, CaGeO₃:Mn²⁺, Cal₂:Eu²⁺ in SiO₂, Cal₂:Eu²⁺,Mn²⁺ in SiO₂, CaLaBO₄:Eu³⁺, CaLaB₃O₇:Ce³⁺,Mn²⁺, Ca₂La₂BO_{6.5}:Pb²⁺, Ca₂MgSi₂O₇, Ca₂MgSi₂O₇:Ce³⁺, CaMgSi₂O₆:Eu²⁺, Ca₃MgSi₂O₈:Eu²⁺, Ca₂MgSi₂O₇:Eu²⁺, CaMgSi₂O₆:Eu²⁺,Mn²⁺, Ca₂MgSi₂O₇:Eu²⁺,Mn²⁺, CaMoO_{4,} CaMoO₄:Eu³⁺, CaO:Bi³⁺, CaO:Cd²⁺, CaO:Cu⁺, CaO:Eu³⁺, CaO:Eu³⁺, Na⁺, CaO:Mn²⁺, CaO:Pb²⁺, CaO:Sb³⁺, CaO:Sm³⁺, CaO:Tb³⁺, CaO:TI, CaO:Zn²⁺, Ca₂P₂O₇:Ce³⁺, α-Ca₃(PO₄)₂:Ce³⁺, β-Ca₃(PO₄)₂:Ce³⁺, Ca₅(PO₄)₃Cl:Eu²⁺, Ca₅(PO₄)₃Cl:Mn²⁺, Ca₅(PO₄)₃Cl:Sb³⁺, Ca₅(PO₄)₃Cl:Sn²⁺, β-Ca₃(PO₄)₂:EU²⁺,Mn²⁺, Ca₅(PO₄)₃F:Mn²⁺, Ca₅(PO₄)₃F:Sb³⁺, Caₛ(PO₄)₃F:Sn²⁺, α-Ca₃(PO₄)₂:Eu²⁺, β-Ca₃(PO₄)₂:Eu²⁺, Ca₂P₂O₇:Eu²⁺, Ca₂P₂O₇:Eu²⁺,MF²⁺, CaP₂O₆:Mn²⁺, α-Ca₃(PO₄)₂:Pb²⁺, α-Ca₃(PO₄)₂:Sn²⁺, β-Ca₃(PO₄)₂:Sn²⁺, β-Ca₂P₂O₇:Sn,Mn, α-Ca₃(PO₄)₂:Tr, CaS:Bi³⁺, CaS:Bi³⁺,Na, CaS:Ce³⁺, CaS:Eu²⁺, CaS:Cu⁺,Na⁺, CaS:La³⁺, CaS:Mn²⁺, CaSO₄:Bi, CaSO₄:Ce³⁺, CaSO₄:Ce³⁺,Mn²⁺, CaSO₄:Eu²⁺, CaSO₄:Eu²⁺,Mn^{z+}, CaSO₄:Pb²⁺, CaS:Pb²⁺, CaS:Pb²⁺,Cl, CaS:Pb²⁺,Mn²⁺, CaS:Pr³⁺,Pb²⁺,Cl, CaS:Sb³⁺, CaS:Sb³⁺,Na, CaS:Sm³⁺, CaS:S²⁺, CaS:Sn²⁺,F, CaS:Tb³⁺, CaS:Tb³⁺,Cl, CaS:Y³⁺, CaS:Yb²⁺, CaS:Yb²⁺,Cl, CaSiO₃:Ce³⁺, Ca₃SiO₄Cl₂:Eu²⁺, Ca₃SiO₄Cl₂:Pb²⁺, CaSiO₃:Eu²⁺, CaSiO₃:Mn²⁺,Pb, CaSiO₃:Pb²⁺, CaSiO₃:Pb²⁺,Mn²⁺, CaSiO₃:Ti⁴⁺, CaSr₂(PO₄)₂:Bi³⁺, β-(Ca,Sr)₃(PO₄)₂:Sn²⁺Mn²⁺, CaTi_{0.9}Al_{0.1}O₃:Bi³⁺, CaTiO₃:Eu³⁺, CaTiO₃:Pr³⁺, Ca₅(VO₄)₃Cl, CaWO₄, CaWO₄:Pb²⁺, CaWO₄:W, Ca₃WO₆:U, CaYAlO₄:Eu³⁺, CaYBO₄:Bi³⁺, CaYBO₄:Eu³⁺, CaYB_{0.8}O_{3.7}:Eu³⁺, CaY₂ZrO₆:Eu³⁺, (Ca,Zn,Mg)₃(PO₄)₂:Sn, CeF₃, (Ce,Mg)BaAl₁₁O₁₈:Ce, (Ce,Mg)SrAl₁₁O₁₈:Ce, CeMgAl₁₁O₁₉:Ce:Tb, Cd₂B₆O₁₁:Mn²⁺, CdS:Ag⁺,Cr, CdS:In, CdS:In, CdS:In,Te, CdS:Te, CdWO₄, CsF, Csl, Csl:Na⁺, Csl:TI, (ErCl₃)_{0.25}(BaCl₂)_{0.75}, GaN:Zn, Gd₃Ga₅O₁₂:Cr³⁺, Gd₃Ga₅O₁₂:Cr,Ce, GdNbO₄:Bi³⁺, Gd₂O₂S:Eu³⁺, Gd₂O₂Pr³⁺, Gd₂O₂S:Pr,Ce,F, Gd₂O₂S:Tb³⁺, Gd₂SiO₅:Ce³⁺, KAl₁₁O₁₇:TI⁺, KGa₁₁O₁₇:Mn²⁺, K₂La₂Ti₃O₁₀:Eu, KMgF₃:Eu²⁺, KMgF₃:Mn²⁺, K₂SiF₆:Mn⁴⁺, LaAl₃B₄O₁₂:Eu³⁺, LaAlB₂O₆:Eu³⁺, LaAlO₃:Eu³⁺, LaAlO₃:Sm³⁺, LaAsO₄:Eu³⁺, LaBr₃:Ce³⁺, LaBO₃:Eu³⁺, (La,Ce,Tb)PO₄:Ce:Tb, LaCl₃:Ce³⁺, La₂O₃:Bi³⁺, LaOBr:Tb³⁺, LaOBr:Tm³⁺, LaOCl:Bi³⁺, LaOCl:Eu³⁺, LaOF:Eu³⁺, La₂O₃:Eu³⁺, La₂O₃:Pr³⁺, La₂O₂S:Tb³⁺, LaPO₄:Ce³⁺, LaPO₄:Eu³⁺, LaSiO₃Cl:Ce³⁺, LaSiO₃Cl:Ce³⁺,Tb³⁺, LaVO₄:Eu³⁺, La₂W₃O₁₂:Eu³⁺, LiAlF₄:Mn²⁺, LiAl₅O₈:Fe³⁺, LiAlO₂:Fe³⁺, LiAlO₂:Mn²⁺, LiAl₅O₈:Mn²⁺, Li₂CaP₂O₇:Ce³⁺,Mn²⁺, LiCeBa₄Si₄O₁₄:Mn²⁺, LiCeSrBa₃Si₄O₁₄:Mn²⁺, LiInO₂:Eu³⁺, LiInO₂:Sm³⁺, LiLaO₂:Eu³⁺, LuAlO₃:Ce³⁺, (Lu,Gd)₂SiO₅:Ce³⁺, Lu₂SiO₅:Ce³⁺, Lu₂Si₂O₇:Ce³⁺, LuTaO₄:Nb⁵⁺, Lu₁₋ₓYₓAlO₃:Ce³⁺, MgAl₂O₄:Mn²⁺, MgSrAl₁₀O₁₇:Ce, MgB₂O₄:Mn²⁺, MgBa₂(PO₄)₂:Sn²⁺, MgBa₂(PO₄)₂:U, MgBaP₂O₇:Eu²⁺, MgBaP₂O₇:Eu²⁺,Mn²⁺, MgBa₃Si₂O₈:Eu²⁺, MgBa(SO₄)₂:Eu²⁺, Mg₃Ca₃(PO₄)₄:Eu²⁺, MgCaP₂O₇:Mn²⁺, Mg₂Ca(SO₄)₃:Eu²⁺, Mg₂Ca(SO₄)₃:Eu²⁺,Mn², MgCeAlₙO₁₉:Tb³⁺, Mg₄(F)GeO₆:Mn²⁺, Mg₄(F)(Ge,Sn)O₆:Mn²⁺, MgF₂:Mn²⁺, MgGa₂O₄:Mn²⁺, Mg₈Ge₂O₁₁F₂:Mn⁴⁺, MgS:Eu²⁺, MgSiO₃:Mn²⁺, Mg₂SiO₄:Mn²⁺, Mg₃SiO₃F₄:Ti⁴⁺, MgSO₄:Eu²⁺, MgSO₄:Pb²⁺, MgSrBa₂Si₂O₇:Eu²⁺, MgSrP₂O₇:Eu²⁺, MgSr₅(PO₄)₄:Sn²⁺, MgSr₃Si₂O₈:Eu²⁺,Mn²⁺, Mg₂Sr(SO₄)₃:Eu²⁺, Mg₂TiO₄:Mn⁴⁺, MgWO₄, MgYBO₄:Eu³⁺, Na₃Ce(PO₄)₂:Tb³⁺, Nal:Tl, Na_{1.23}K_{0.42}Eu_{0.12}TiSi₄O₁₁:Eu³⁺, Na_{1.23}K_{0.42}Eu_{0.12}TiSi₅O₁₃·xH₂O:Eu³⁺, Na_{1.29}K_{0.46}Er_{0.08}TiSi₄O₁₁:Eu³⁺, Na₂Mg₃Al₂Si₂O₁₀:Tb, Na(Mg₂₋ₓmnₓ)LiSi₄O₁₀F₂:Mn, NaYF₄:Er³⁺, Yb³⁺, NaYO₂:Eu³⁺, P46(70%) + P47 (30%), SrAl₁₂O₁₉:Ce³⁺, Mn²⁺, SrAl₂O₄:Eu²⁺, SrAl₄O₇:Eu³⁺, SrAl₁₂O₁₉:Eu²⁺, SrAl₂S₄:Eu²⁺, Sr₂B₅O₉Cl:Eu²⁺, SrB₄O₇:Eu²⁺(F,Cl,Br), SrB₄O₇:Pb²⁺, SrB₄O₇:Pb²⁺, Mn²⁺, SrB₈O₁₃:Sm²⁺, SrₓBa_{y}Cl_{z}Al₂O_{4-z/2}: Mn²⁺, Ce³⁺, SrBaSiO₄:Eu²⁺, Sr(Cl,Br,I)₂:Eu²⁺ in SiO₂, SrCl₂:Eu²⁺ in SiO₂, Sr₅Cl(PO₄)₃:Eu, Sr_{w}FₓB₄O_{6.5}:Eu²⁺, Sr_{w}FₓB_{y}O_{z}:Eu²⁺,Sm²⁺, SrF₂:Eu²⁺, SrGa₁₂O₁₉:Mn²⁺, SrGa₂S₄:Ce³⁺, SrGa₂S₄:Eu²⁺, SrGa₂S₄:Pb²⁺, SrIn₂O₄:Pr³⁺, Al³⁺, (Sr,Mg)₃(PO₄)₂:Sn, SrMgSi₂O₆:Eu²⁺, Sr₂MgSi₂O₇:Eu²⁺, Sr₃MgSi₂O₈:Eu²⁺, SrMoO₄:U, SrO.3B₂O₃:Eu²⁺,Cl, ß-SrO·3B₂O₃:Pb²⁺, ß-SrO-3B₂O₃ :Pb²⁺,Mn²⁺, α-SrO·3B₂O₃:Sm²⁺, Sr₆P₅BO₂₀:Eu, Sr₅(PO₄)₃Cl:Eu²⁺, Sr₅(PO₄)₃Cl:Eu²⁺,Pr³⁺, Sr₅(PO₄)₃Cl:Mn²⁺, Sr₅(PO₄)₃Cl:Sb³⁺, Sr_{Z}P₂O₇:Eu²⁺, β-Sr₃(PO₄)₂:Eu²⁺, Sr₅(PO₄)₃F:Mn²⁺, Sr₅(PO₄)₃F:Sb³⁺, Sr₅(PO₄)₃F:Sb³⁺,Mn²⁺, Sr₅(PO₄)₃F:Sn²⁺, Sr₂P₂O₇:Sn²⁺, β-Sr₃(PO₄)₂:Sn²⁺, β-Sr₃(PO₄)₂:Sn²⁺,Mn²⁺(Al), SrS:Ce³⁺, SrS:Eu²⁺, SrS:Mn²⁺, SrS:Cu⁺,Na, SrSO₄:Bi, SrSO₄:Ce³⁺, SrSO₄:Eu²⁺, SrSO₄:Eu²⁺,Mn²⁺, Sr₅Si₄O₁₀Cl₆:Eu²⁺, Sr₂SiO₄:Eu²⁺, SrTiO₃:Pr³⁺, SrTiO₃:Pr³⁺,Al³⁺, Sr₃WO₆:U, SrY₂O₃:Eu³⁺, ThO₂:Eu³⁺, ThO₂:Pr³⁺, ThO₂:Tb³⁺, YAl₃B₄O₁₂:Bi³⁺, YAl₃B₄O₂₁:Ce³⁺, YAl₃B₄O₁₂:Ce³⁺,Mn, YAl₃B₄O₁₂Ce³⁺,Tb³⁺, YAl₃B₄O₁₂:EU³⁺, YAl₃B₄O₁₂:Eu³⁺,Cr³⁺, YAl₃B₄O₁₂:Th⁴⁺,Ce³⁺,Mn²⁺, YAlO₃:Ce³⁺, Y₃Al₅O₁₂:Ce³⁺, Y₃Al₅O₁₂:Cr³⁺, YAlO₃:Eu³⁺, Y₃Al₅O₁₂:Eu^{3r}, Y₄Al₂O₉:Eu³⁺, Y₃Al₅O₁₂:Mn⁴⁺, YAlO₃:Sm³⁺, YAlO₃:Tb³⁺, Y₃Al₅O₁₂:Tb³⁺, YAsO₄:Eu³⁺, YBO₃:Ce³⁺, YBO₃:Eu³⁺, YF₃:Er³⁺,Yb³⁺, YF₃:Mn²⁺, YF₃:Mn²⁺,Th⁴⁺, YF₃:Tm³⁺,Yb³⁺, (Y,Gd)BO₃:Eu, (Y,Gd)BO₃:Tb, (Y,Gd)₂O₃:Eu³⁺, Y_{1.34}Gd_{0.60}O₃(Eu,Pr), Y₂O₃:Bi³⁺, YOBr:Eu³⁺, Y₂O₃:Ce, Y₂O₃:Er³⁺, Y₂O₃:Eu³⁺(YOE), Y₂O₃:Ce³⁺,Tb³⁺, YOCl:Ce³⁺, YOCl:Eu³⁺, YOF:Eu³⁺ YOF:Tb³⁺, Y₂O₃:Ho³⁺, Y₂O₂S:Eu³⁺, Y₂O₂S:Pr³⁺, Y₂O₂S:Tb³⁺, Y₂O₃:Tb³⁺, YPO₄:Ce³⁺, YPO₄:Ce³⁺,Tb³⁺, YPO₄:Eu³⁺, YPO₄:Mn²⁺,Th⁴⁺, YPO₄:V⁵⁺, Y(P,V)O₄:Eu, Y₂SiO₅:Ce³⁺, YTaO₄, YTaO₄:Nb⁵⁺, YVO₄:Dy³⁺, YVO₄:Eu³⁺, ZnAl_{z}O₄:Mn²⁺, ZnB₂O₄:Mn²⁺, ZnBa₂S₃:Mn²⁺, (Zn,Be)₂SiO₄:Mn²⁺, Zn_{0.4}Cd_{0.6}S:Ag, Zn_{0.6}Cd_{0.4}S:Ag, (Zn,Cd)S:Ag,Cl, (Zn,Cd)S:Cu, ZnF₂:Mn²⁺, ZnGa₂O₄, ZnGa₂O₄:Mn²⁺, ZnGa₂S₄:Mn²⁺, Zn₂GeO₄:Mn²⁺, (Zn,Mg)F₂:Mn²⁺, ZnMg₂(PO₄)₂:Mn²⁺, (Zn,Mg)₃(PO₄)₂:Mn²⁺, ZnO:Al³⁺,Ga³⁺, ZnO:Bi³⁺, ZnO:Ga³⁺, ZnO:Ga, ZnO-CdO:Ga, ZnO:S, ZnO:Se, ZnO:Zn, ZnS:Ag⁺,Cl⁻, ZnS:Ag,Cu,Cl, ZnS:Ag,Ni, ZnS:Au,In, ZnS-CdS (25-75), ZnS-CdS (50-50), ZnS-CdS (75-25), ZnS-CdS:Ag,Br,Ni, ZnS-CdS:Ag⁺,Cl, ZnS-CdS:Cu,Br, ZnS-CdS:Cu,I, ZnS:Cl⁻, ZnS:Eu²⁺, ZnS:Cu, ZnS:Cu⁺,Al³⁺, ZnS:Cu⁺,Cl⁻, ZnS:Cu,Sn, ZnS:Eu²⁺, ZnS:Mn²⁺, ZnS:Mn,Cu, ZnS:Mn²⁺,Te²⁺, ZnS:P, ZnS:P³⁻,Cl⁻, ZnS:Pb²⁺, ZnS:Pb²⁺,Cl⁻, ZnS:Pb,Cu, Zn₃(PO₄)₂:Mn²⁺, Zn_{z}SiO₄:Mn²⁺, Zn₂SiO₄:Mn²⁺,As⁵⁺, Zn₂SiO₄:Mn, Sb₂O₂, Zn₂SiO₄:Mn²⁺,P, Zn₂SiO₄:Ti⁴⁺, ZnS:Sn²⁺, ZnS:Sn,Ag, ZnS:Sn²⁺,Li⁺, ZnS:Te,Mn, ZnS-ZnTe:Mn²⁺, ZnSe:Cu⁺,Cl, ZnWO₄

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

### Beispiele

### 1. Herstellung von co-dotierten Ca₂Si₅N₈:Eu (mit 2% und 10% Eu)

### Beispiel 1 a: Herstellung von Ca₂Si₅N₈:Eu(2%) als Referenz-Leuchtstoff

2.8730 g CaH₂ (Alfa Aesar 99,8%), 0.2479 g EuF₃ (ChemPur 99.9%) und 6.9356 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 1b: Herstellung von mit 0,1% Hf co-dotiertem Ca₂Si₅N₈:Eu(2%)

2.4428 g CaH₂ (Alfa Aesar 99,8%), 0.2477 g EuF₃ (ChemPur 99.9%), 0.0151 g HfF₄ (Alfa Aesar 99,9%) und 6.9299 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 1c: Herstellung von mit 0,1% Zr co-dotiertem Ca₂Si₅N₈:Eu(2%)

2.4441 g CaH₂ (Alfa Aesar 99,8%), 0.2479 g EuF₃ (ChemPur 99.9%), 0.0099 g ZrF₄ (Alfa Aesar 98%) und 6.9335 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 1d: Herstellung von Ca₂Si₅N₈:Eu(10%) als Referenz-Leuchtstoff

2.1342 g CaH₂ (Alfa Aesar 99,8%), 1.1772 g EuF₃ (ChemPur 99.9%) und 6.5858 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 1e: Herstellung von mit 0,1% Hf co-dotiertem Ca₂Si₅N₈:Eu²⁺(10%)

2.1302 g CaH₂ (Alfa Aesar 99,8%), 1.1762 g EuF₃ (ChemPur 99.9%), 0.0143 g HfF₄ (Alfa Aesar 99,9%) und 6.5807 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 1f: Herstellung von mit 0,1% Zr co-dotiertem Ca₂Si₅N₈:Eu²⁺(10%)

2.1312 g CaH₂ (Alfa Aesar 99,8%), 1.1768 g EuF₃ (ChemPur 99.9%), 0.0094 g ZrF₄ (Alfa Aesar 99,9%) und 6.5839 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### 2. Herstellung von co-dotierten Sr₂Si₅N₈:Eu ( mit 2%Eu)

### Beispiel 2a: Herstellung von Sr₂Si₅N₈:Eu(2%) als Referenz-Leuchtstoff

4.4164g Sr₃N₂, 0.1942 g EuF₃ (ChemPur 99.9%) und 5.4337 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas(N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 2b: Herstellung von mit 0,1% Hf co-dotiertem Sr₂Si₅N₈:Eu(2%)

4.4100 g Sr₃N₂, 0.1942 g EuF₃ (ChemPur 99.9%), 0.0118 g HfF₄ (Alfa Aesar 99,9%) und 5.4314 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 2c: Herstellung von mit 0,1% Zr co-dotiertem Sr₂Si₅N₈:Eu(2%)

4.4118 g Sr₃N₂, 0.1942 g EuF₃ (ChemPur 99.9%), 0.0078 g ZrF₄ (Alfa Aesar 99,9%) und 5.4336 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### 3. Herstellung von co-dotierten Ba₂Si₅N₈:Eu (mit 2%Eu)

### Beispiel 3a: Herstellung von Ba₂Si₅N₈:Eu(2%) als Referenz-Leuchtstoff

5.4472 g Ba₃N₂, 0.1584 g EuF₃ (ChemPur 99.9%) und 4.4305 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 3b:Herstellung von mit 0,1% Hf co-dotiertem Ba₂Si₅N₈:Eu(2%)

5.4408 g Ba₃N₂, 0.1584 g EuF₃ (ChemPur 99.9%), 0.0096 g HfF₄ (Alfa Aesar 99,9%) and 4.4298 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 3c: Herstellung von mit 0,1% Zr co-dotiertem Ba₂Si₅N₈:Eu(2%)

5.4426 g Ba₃N₂, 0.1584 g EuF₃ (ChemPur 99.9%), 0.0063 g ZrF₄ (Alfa Aesar 99,9%) and 4.4313 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 4: Herstellung von 0.1 % Zr co-dotierten

### Na₂Ca_{0.98}Zr_{0.001}Si_{4.999}N₈:Eu_{0.02} (mit 2% Eu)

0.81469 g CaH₂ (Alfa Aesar 99,8%), 0.9288 g NaH (95 %, Sigma Aldrich), 0.2479 g EuF₃ (ChemPur 99.9%), 0.0099 g ZrF₄ (Alfa Aesar 98%) und 6.9335 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

### Beispiel 5: Herstellung von 0.1 % Zr co-dotierten

### Na_{1.99}Ca_{0.97}Zr_{0.001}Si_{4.999}N₈:Eu_{0.02} Ce_{0.01}

### (mit 2% Eu und 1% Ce)

0.7897 g CaH₂ (Alfa Aesar 99,8%), 0.9146 g NaH (95 %, Sigma Aldrich), 0.2479 g EuF₃ (ChemPur 99.9%), 0.1169 g CeF3 (Chempur 99,9 %), 0.0099 g ZrF₄ (Alfa Aesar 98%) und 6.9335 g Si₃N₄ (UBE 99,99%) werden in einer Glovebox unter Sauerstoff- und Feuchteauschluss innig miteinander vermischt und anschließend in einen Korundtiegel, der mit Molybdän ausgekleidet ist, überführt. Dann wird der Tiegel in einen mit Formiergas (N₂/H₂ = 90/10) gespülten Rohrofen überführt und nach dem Verschließen des Ofens für 14 h bei 1400 °C kalziniert. Schließlich wird der erhaltene Sinterkuchen, gemahlen, gesiebt und klassiert.

**Tabelle 1: Optische Eigenschaften von M_{1,98}Si₅N₈:Eu_{0,02} (M = Ca, Sr, Ba) im Vergleich zum co-dotierten, erfindungsgemäßen Leuchtstoff (QA = Quantenausbeute)**

| **Zusammensetzung** | **Emissionsmax. bei [nm]** | **QA bei 450 nm [%]** | **CIE 1931 x, y** |
|---|---|---|---|
| Ca₂Si₅N₈:Eu²⁺(2,0%) | 609 | 79 | 0.601 |
| | | | 0.397 |
| Ca₂Si₅N₈:Eu²⁺(2,0%), Hf⁴⁺(0,1%) | 608 | 84 | 0.600 |
| | | | 0.399 |
| Ca₂Si₅N₈:Eu²⁺(2,0%), Zr⁴⁺(0,1%) | 608 | 86 | 0.600 |
| | | | 0.398 |
| Sr₂Si₅N₈:Eu²⁺(2,0%) | 619 | 71 | 0.629 |
| | | | 0.369 |
| Sr₂Si₅N₈:Eu²⁺(2,0%), Hf⁴⁺(0,1%) | 617 | 87 | 0.621 |
| | | | 0.372 |
| Sr₂Si₅N₈:Eu²⁺(2,0%), Zr⁴⁺(0,1%) | 617 | 80 | 0.629 |
| | | | 0.376 |
| Ba₂Si₅N₈:Eu²⁺(2,0%) | 583 | 76 | 0.540 |
| | | | 0.458 |
| Ba₂Si₅N₈:Eu²⁺(2,0%), Hf⁴⁺(0,1%) | 581 | 84 | 0.535 |
| | | | 0.462 |
| Ba₂Si₅N₈:Eu²⁺(2,0%), Zr⁴⁺(0,1%) | 581 | 88 | 0.532 |
| | | | 0.466 |

### Beschreibung der Abbildungen

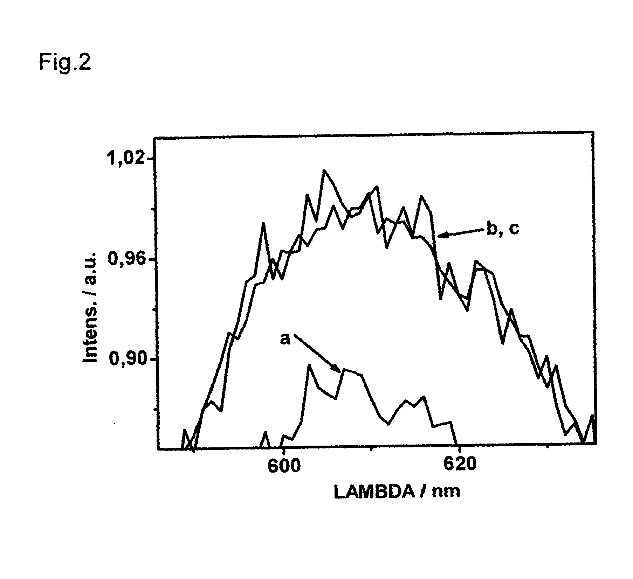

Im folgenden soll die Erfindung anhand mehrerer Ausführungsbeispiele näher erläutert werden. Es zeigen:

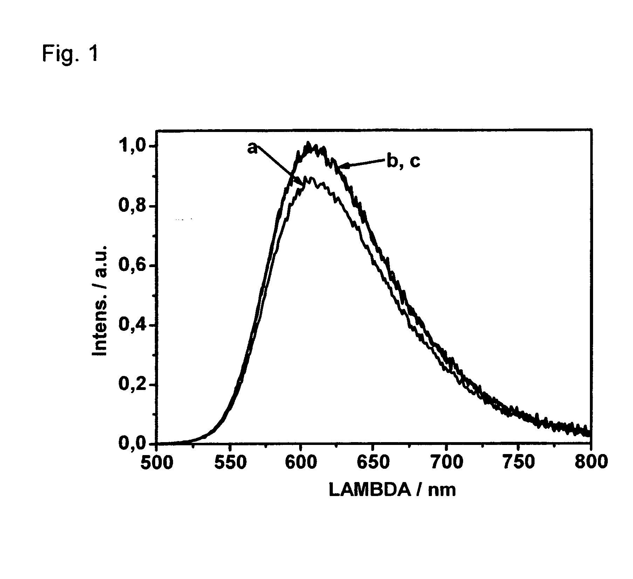

Fig. 1: zeigt das Emissionsspektrum von Ca_{1,98}Si₅N₈:Eu_{0,02} und co-dotiertem Leuchtstoff bei 450 nm Anregungswellenlänge. Hier bedeuten
   a) der nicht co-dotierte Leuchtstoff
   b) Ca_{1,98}Si₅N₈:Eu_{0,02} mit 0.1% Zr codotiert und
   c) Ca_{1,98}Si₅N₈:Eu:_{0,02} mit 0.1% Hf codotiert
Fig.2 : zeigt eine Ausschnittsvergrößerung von Fig.1 zur besseren Unterscheidung. Die Emissionsspektren von b) und c) sind annährend identisch.

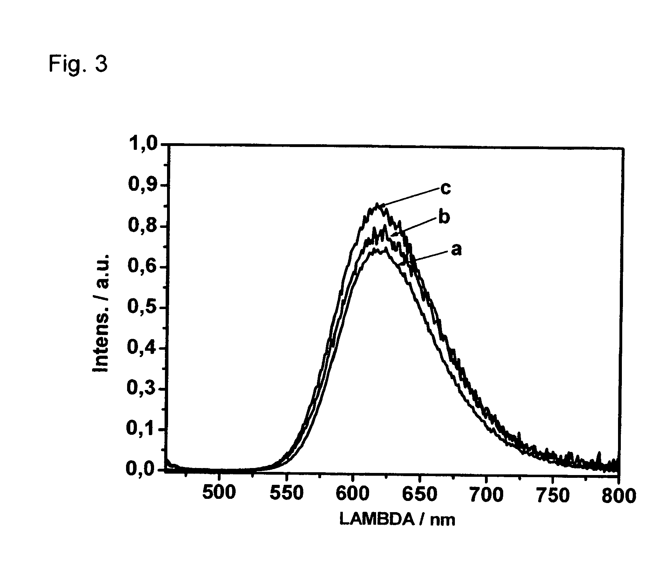

Fig.3: zeigt das Emissionsspektrum von Sr_{1,98}Si₅N₈:Eu_{0,02} und co-dotiertem Leuchtstoff bei einer Anregungswellenlänge 450 nm. Hier bedeuten
   a) der nicht co-dotierte Leuchtstoff
   b) Sr_{1,98}Si₅N₈:Eu_{0,02} mit 0.1% Zr codotiert und
   c) Sr_{1,98}Si₅N₈:Eu_{0,02} mit 0.1% Hf codotiert.

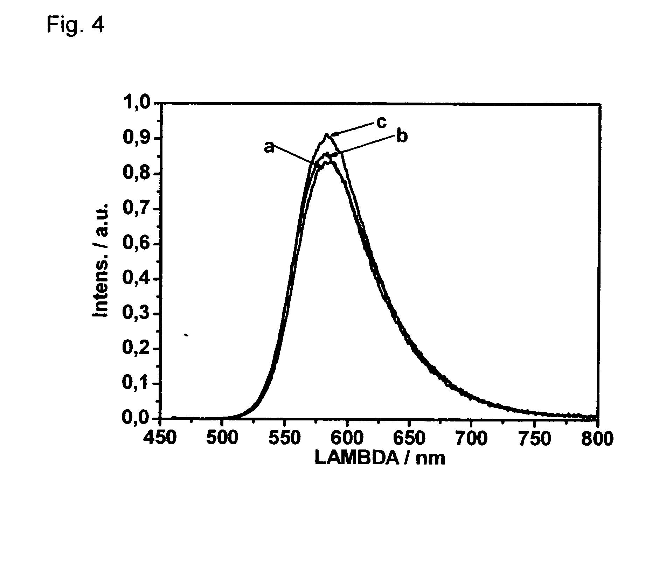

Fig. 4 : zeigt das Emissionsspektrum von Ba_{1,98}Si₅N₈:Eu_{0,02} und co-dotiertem, erfindungsgemäßen Leuchtstoff bei Anregungswellenlänge 450 nm. Es bedeuten a) der nicht co-dotierte Leuchtstoff, b) Ba_{1,98}Si₅N₈:Eu_{0,02} mit 0.1% Zr co-dotiert c) Ba_{1,98}Si₅N₈:Eu_{0,02} mit 0.1% Hf codotiert.

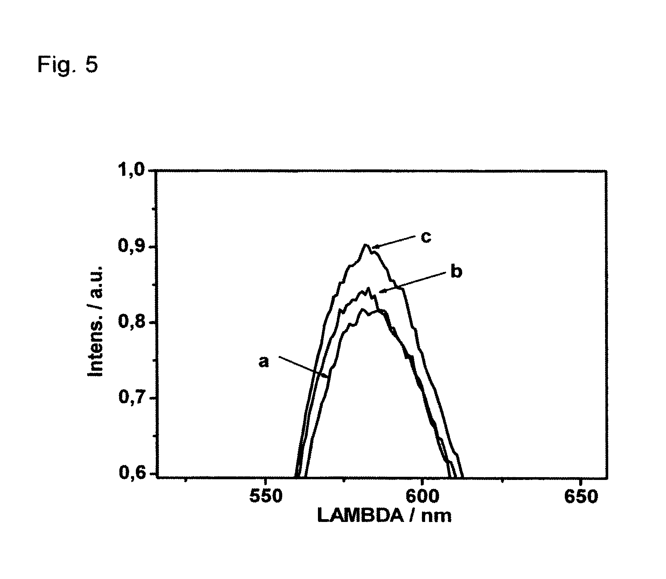

Fig. 5: zeigt eine Ausschnittsvergrößerung von Fig. 4 zur besseren Unterscheidung der Emissionsspektren.

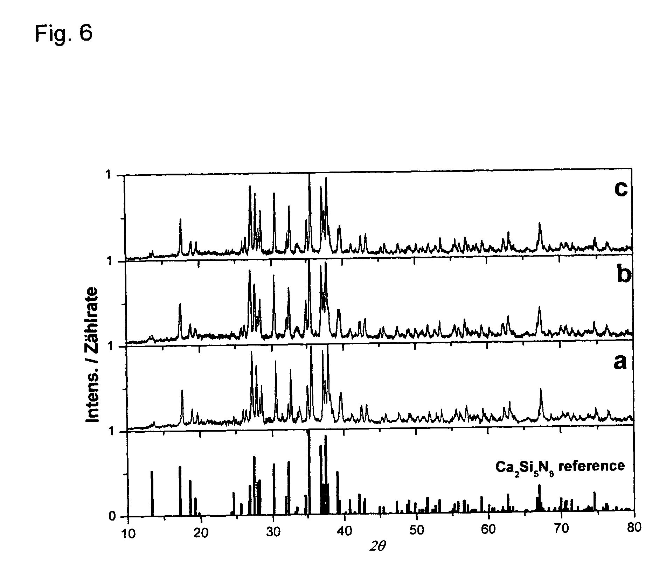

Fig. 6: zeigt Röntgenpulverdiffraktogramme von a) der nicht co-dotierte Leuchtstoff b) Ca_{1,98}Si₅N₈:Eu_{0,02} mit 0.1 % Zr co-dotiert c) Ca_{1,98}Si₅N₈:Eu_{0,02} mit 0.1% Hf co-dotiert

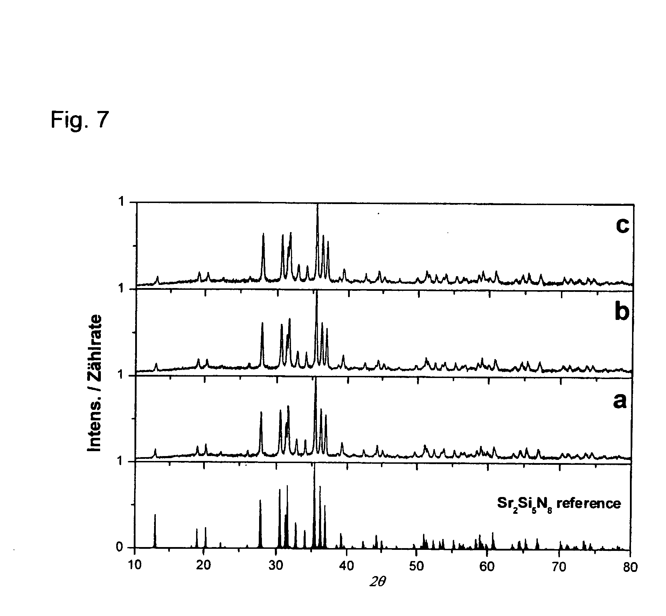

Fig. 7: zeigt Röntgenpulverdiffraktogramme von a) der nicht co-dotierte Leuchtstoff b) Sr_{1,98}Si₅N₈:Eu_{0,02} mit 0.1% Zr co-dotiert c) Sr_{1,98}Si₅N₈:Eu_{0,02} mit 0.1 % Hf co-dotiert.

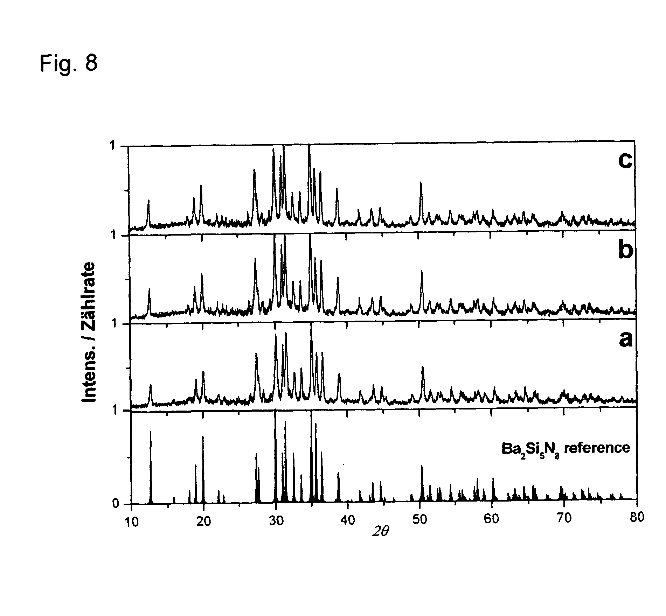

Fig. 8: zeigt Röntgenpulverdiffraktogramme von a) der nicht co-dotierte Leuchtstoff b) Ba₁,₉₈Si₅N₈:Eu_{0,02} mit 0.1% Zr co-dotiert c) Ba_{1,98}Si₅N₈:Eu_{0,02} mit 0.1 % Hf co-dotiert
Fig. 9: zeigt die schematische Abbildung einer Leuchtdiode mit einer Leuchtstoff-haltigen Beschichtung. Das Bauteil umfasst eine Chip-artige LED 1 als Strahlungsquelle. Die LED ist ein einem becherförmigen Reflektor angebracht, der von einem Justagerahmen 2 gehalten wird. Der Chip 1 ist über ein Flachkabel 7 mit einem ersten Kontakt 6 und direkt mit einem zweiten elektrischen Kontakt 6'verbunden. Auf die innere Wölbung des Reflektorsbechers wurde eine Beschichtung aufgebracht, die einen erfindungsgemäßen Konversionsleuchtstoff enthält. Die Leuchtstoffe werden entweder getrennt voneinander oder als Mischung eingesetzt. (Liste der Teilenummern: 1 Leuchtdiode, 2 Reflektor, 3 Harz, 4 Konversionsleuchtstoff, 5 Diffuser, 6 Elektroden, 7 Flachkabel)

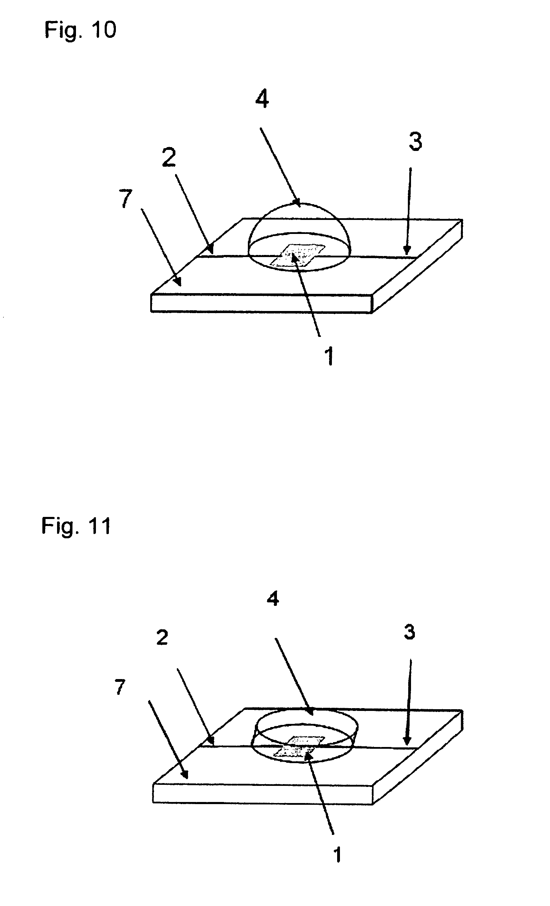

Fig. 10: zeigt ein COB (Chip on board) Package des Typs InGaN, das als Lichtquelle (LED) für weißes Licht dient (1=Halbleiterchip; 2,3 = elektr. Anschlüsse; 4 = Konversionsleuchtstoff; 7 = Board (Platine) Der Leuchtstoff ist in einer Bindemittellinse verteilt, die gleichzeitig ein sekundäres optisches Element darstellt und die Lichtabstrahlcharakteristik als Linse beeinflusst.
Fig. 11: zeigt ein COB (Chip on board) Package des Typs InGaN, das als Lichtquelle (LED) für weißes Licht dient (1=Halbleiterchip; 2,3 = elektr. Anschlüsse; 4 = Konversionsleuchtstoff; 7 = Board (Platine) Der Leuchtstoff befindet sich in einer dünnen Bindemittelschicht verteilt direkt auf dem LED Chip. Ein sekundäres optisches Element bestehend aus einem transparenten Material kann darauf platziert werden.

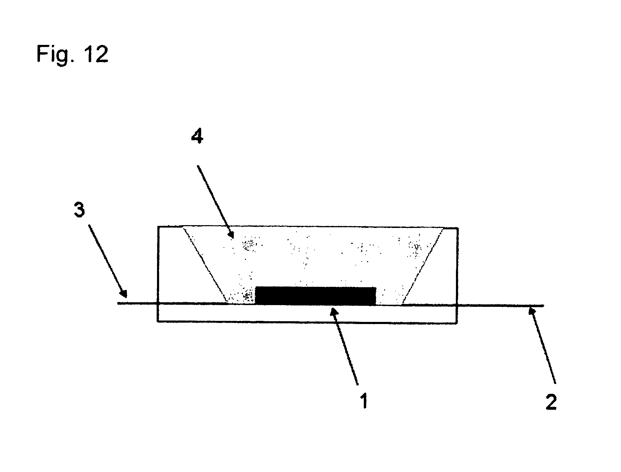

Fig.12: zeigt ein Package, das als Lichtquelle (LED) für weißes Licht dient (1=Halbleiterchip; 2,3 = elektr. Anschlüsse; 4 = Konversionsleuchtstoff in Kavität mit Reflektor). Der Konversionsleuchtstoff befindet sich in einem Bindemittel dispergiert, wobei die Mischung die Kavität ausfüllt.

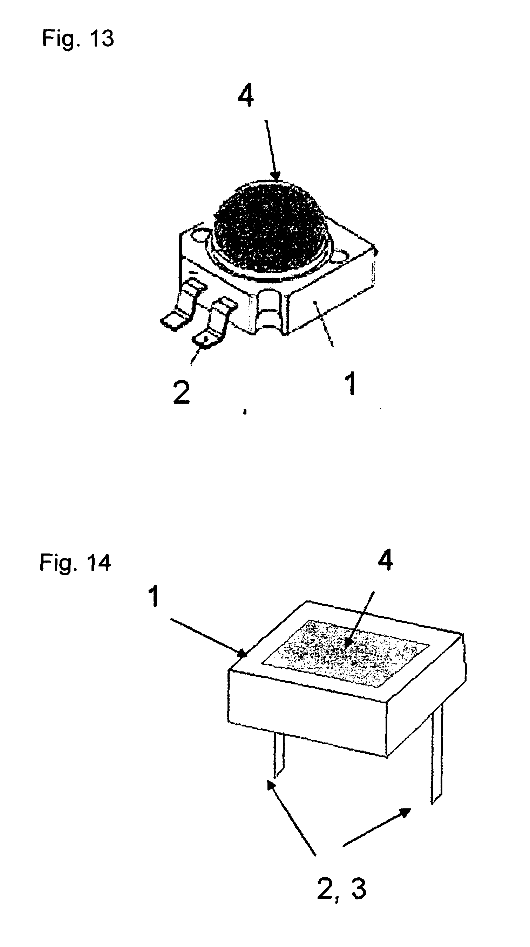

Fig. 13: zeigt ein Package , wobei 1= Gehäuse; 2 = elektr. Anschluss; 4= Halbleiterchip bedeutet, und der Hohlraum unterhalb der Linse komplett mit dem erfindungsgemäßen Konversionsleuchtstoff ausgefüllt ist. Dieses Package hat den Vorteil, dass eine größere Menge Konversionsleuchtstoff verwendet werden kann. Dieser kann auch als Remote Phosphor wirken.
Fig. 14: zeigt ein SMD-Package (Surface mounted package) wobei 1= Gehäuse; 2, 3 = elektr. Anschlüsse, 4 = Konversionsschicht bedeutet. Der Halbleiterchip ist komplett mit dem erfindungsgemäßen Leuchtstoff bedeckt. Das SMD-Design hat den Vorteil, dass es eine kleine Bauform hat und somit in herkömmliche Leuchten passt.

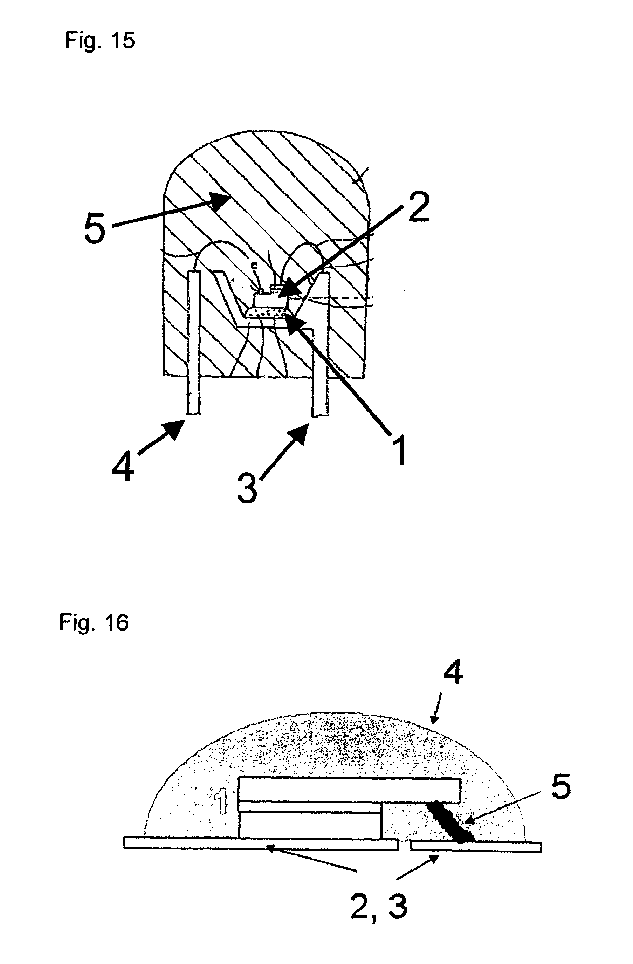

Fig. 15: zeigt ein T5-Package, wobei 1= Konversionsleuchtstoff; 2 = Chip; 3,4 = elektr. Anschlüsse; 5 = Linse mit transparenten Harz bedeutet. Der Konversionsleuchtstoff befindet sich auf der Rückseite des LED-Chips, was den Vorteil hat, dass der Leuchtstoff über die metallischen Anschlüsse gekühlt wird.
Fig. 16: zeigt eine schematische Abbildung einer Leuchtdiode mit 1= Halbleiterchip; 2,3 = elektr. Anschlüsse; 4 =Konversionsleuchtstoff, 5 = Bonddraht, wobei der Leuchtstoff in einem Bindemittel als Top Globe aufgebracht ist. Diese Form der Leuchtstoff-/Bindemittelschicht kann als sekundäres optisches Element wirken und z. B. die Lichtausbreitung beeinflussen.

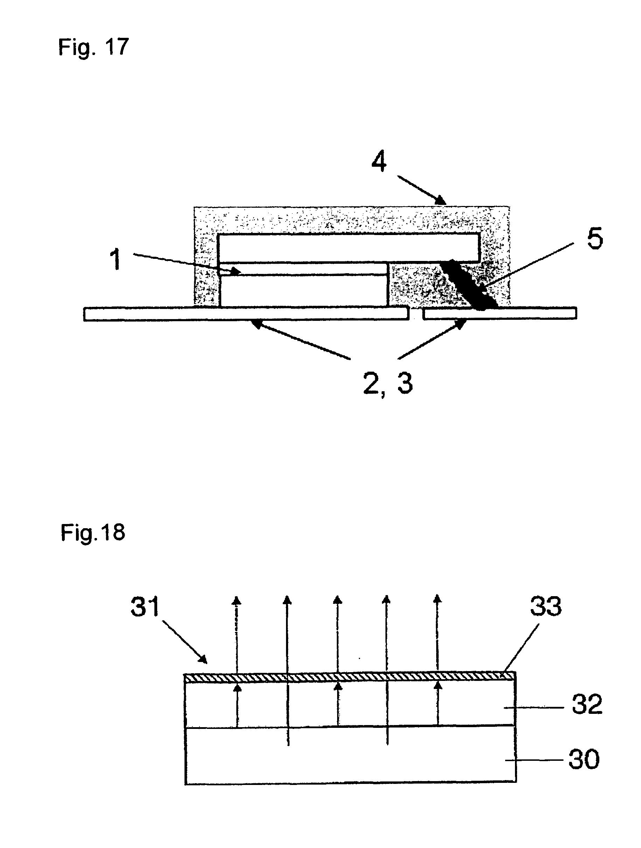

Fig. 17: zeigt eine schematische Abbildung einer Leuchtdiode mit 1= Halbleiterchip; 2,3 = elektr. Anschlüsse; 4 =Konversionsleuchtstoff, 5 = Bonddraht, wobei der Leuchtstoff als dünne Schicht in einem Bindemittel dispergiert aufgebracht ist. Auf diese Schicht lässt sich leicht ein weiteres, als sekundäres optisches Element wirkendes Bauteil, wie z.B eine Linse aufbringen.
Fig. 18: zeigt ein Beispiel für eine weitere Anwendung, wie sie im Prinzip bereits aus US-B 6,700,322 bekannt ist. Dabei wird der erfindungsgemäße Leuchtstoff zusammen mit einer OLED angewendet. Die Lichtquelle ist eine organisch lichtemittierende Diode 31, bestehend aus der eigentlichen organischen Folie 30 und einem transparenten Substrat 32. Die Folie 30 emittiert insbesondere blaues primäres Licht, erzeugt beispielsweise mittels PVK:PBD:Kumarin (PVK, Abk. für Poly(n-vinylcarbazol); PBD, Abk. für 2-(4-biphenyl)-5-(4-tert.-butylphenyl)-1,3,4-oxadiazol)). Die Emission wird von einer Deckschicht, gebildet aus einer Schicht 33 des erfindungsgemäßen Leuchtstoffs, teilweise in gelbes, sekundär emittiertes Licht umgewandelt, so dass insgesamt durch Farbmischung des primär und sekundär emittierten Lichts eine weiße Emission realisiert wird. Die OLED besteht im wesentlichen aus mindestens einer Schicht eines lichtemittierenden Polymers oder von sog. small molecules zwischen zwei Elektroden, die aus an sich bekannten Materialien bestehen, wie beispielsweise ITO (Abk. für "indium tin oxide") als Anode und ein hochreaktives Metall, wie z.B. Ba oder Ca, als Kathode. Oft werden auch mehrere Schichten zwischen den Elektroden verwendet, die entweder als Lochtransportschicht dienen oder im Bereich der "small molecules" auch als Elektronentransportschichten dienen. Als emittierende Polymere kommen beispielsweise Polyfluorene oder Polyspiro-Materialien zum Einsatz.

## Patentansprüche

1. Verbindung des Typs M₂Si₅N₈:Eu²⁺ mit optionaler Cer-Dotierung, wobei M für ein Erdalkalimetall oder eine Mischung aus mehreren Erdalkalimetallen steht, die zusätzlich mindestens einen Co-Dotanden enthält ausgewählt aus der Gruppe bestehend aus Hafnium, Zirkonium, Lithium, Natrium und Kalium, wobei mindestens ein Co-Dotand ausgewählt ist aus der Gruppe bestehend aus Hafnium und Zirkonium.

2. Verbindung nach Anspruch 1, **gekennzeichnet durch** die Formel I
Ma_{2-y} (Ca,Sr,Ba)_{1-x-y}Si_{5-z}Me_{z}N₈:EuₓCe_{y} (I)
wobei
Ma = Li, Na und/oder K
Me = Hf⁴⁺ und/oder Zr⁴⁺
x = 0,0015 bis 0,20 und
y = 0 bis 0,15
z<4
ist.

3. Verbindung nach Anspruch 1 und/oder 2, **dadurch gekennzeichnet, dass** z < 1, vorzugsweise z < 0,1, noch bevorzugter z = 0,0002 bis 0,02 ist.

4. Verbindung nach einem oder mehreren der Ansprüche 1 bis 3, erhältlich durch Mischen von Siliciumnitrid- , Europium-, Cer- und Calcium- und/oder Strontium- und /oder Barium-haltigen Edukten mit mindestens einem Co-Dotierstoff ausgewählt aus der Gruppe bestehend aus Hafnium-, Zirkonium-, Lithium-, Natrium- und Kalium-haltigen Co-Dotierstoffen nach Festkörperdiffusionsmethoden und anschließender thermischer Nachbehandlung.

5. Verfahren zur Herstellung einer Verbindung nach einem oder mehreren der Ansprüche 1 bis 4 mit folgenden Verfahrensschritten:
a) Herstellen einer Europium- und/oder Cer-dotierten 2-5-8-Erdalkali-siliconitrid-Verbindung, die mit mindestens einem Material ausgewählt aus der Gruppe bestehend aus Hafnium-, Zirkonium-, Lithium-, Natrium- und Kalium-haltigen Materialien co-dotiert wird, durch Mischen von mindestens 4 Edukten ausgewählt aus Siliciumnitrid-, Europium-, Cer-, Calcium-, Strontium-, Barium-, Hafnium-,Zirkonium-, Lithium-, Natrium- und/oder Kalium-haltigen Materialien,
b) Thermische Nachbehandlung der co-dotierten Verbindung.

6. Formkörper enthaltend eine Verbindung nach einem oder mehreren der Ansprüche 1 bis 4, **dadurch gekennzeichnet, dass** er eine raue Oberfläche besitzt, die Nanopartikel ausgewählt aus der Gruppe bestehend aus SiO₂, TiO₂, Al₂O₃, ZnO, ZrO₂ und Y₂O₃ und Mischoxiden daraus und/ oder Partikel mit der Verbindung nach einem oder mehreren der Ansprüche 1 bis 4 mit oder ohne Dotierstoffen ausgewählt aus der Gruppe bestehend aus Europium, Cer, Hafnium, Zirkonium, Lithium, Natrium und Kalium trägt.

7. Formkörper enthaltend eine Verbindung nach einem oder mehreren der Ansprüche 1 bis 4, **dadurch gekennzeichnet, dass** er eine geschlossene Oberflächenbeschichtung besitzt, die ausgewählt ist aus der Gruppe bestehend aus SiO₂, TiO₂, Al₂O₃, ZnO, ZrO₂ und Y₂O₃ oder Mischoxiden daraus und /oder aus der Verbindung nach einem oder mehreren der Ansprüche 1 bis 4 ohne den Aktivator Europium besteht.

8. Formkörper enthaltend eine Verbindung nach einem oder mehreren der Ansprüche 1 bis 4, **dadurch gekennzeichnet, dass** er eine poröse Oberflächenbeschichtung besitzt, die ausgewählt ist aus der Gruppe bestehend aus SiO₂, TiO₂, Al₂O₃, ZnO, ZrO₂ und Y₂O₃ oder Mischoxiden daraus und/ oder aus der Verbindung nach einem oder mehreren der Ansprüche 1 bis 4 mit oder ohne Dotierstoffen ausgewählt aus der Gruppe bestehend aus Europium, Cer, Hafnium, Zirkonium, Lithium, Natrium und Kalium besteht.

9. Formkörper enthaltend eine Verbindung nach einem oder mehreren der Ansprüche 1 bis 4, **dadurch gekennzeichnet, dass** die Oberfläche funktionelle Gruppen trägt, welche eine chemische oder physikalische Anbindung an die Umgebung, vorzugsweise bestehend aus Epoxy- oder Silikonharz, ermöglicht.

10. Verfahren zur Herstellung eines Formkörpers nach einem oder mehreren der Ansprüche 6 bis 9 mit folgenden Verfahrensschritten:
a) Herstellen einer 2-5-8-Europium-dotierten Erdalkali-siliconitrid-Verbindung, die mit Hafnium- und/oder Zirkonium-haltigen Materialien codotiert wird, durch Mischen von mindestens 4 Edukten ausgewählt aus der Gruppe bestehend aus Siliciumnitrid-, Europium-, Cer-, Calcium-, Strontium-, Barium-, Hafnium-, Zirkonium-, Lithium-, Natrium- und Kalium-haltigen Materialien,
b) Thermische Nachbehandlung der codotierten Verbindung und Entstehung eines Formkörpers mit rauer Oberfläche,
c) Beschichtung der rauen Oberfläche mit Nanopartikeln ausgewählt aus der Gruppe bestehend aus SiO₂, TiO₂, Al₂O₃, ZnO, ZrO₂ und/oder Y₂O₃ oder Mischoxide daraus oder mit Nanopartikeln aus der Verbindung nach einem oder mehreren der Ansprüche 1 bis 4 mit oder ohne Dotierstoffen.

11. Beleuchtungseinheit mit mindestens einer Primärlichtquelle, deren Emissionsmaximum im Bereich 250 nm bis 530 nm liegt, vorzugsweise zwischen 390 nm und 480 nm, wobei diese Strahlung teilweise oder vollständig in längerwellige Strahlung konvertiert wird durch eine Verbindung oder Formkörper nach einem oder mehreren der Ansprüche 1 bis 10.

12. Beleuchtungseinheit nach Anspruch 11, **dadurch gekennzeichnet, dass** es sich bei der Lichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 ist, oder um eine lumineszente auf ZnO, TCO (Transparent conducting oxide), ZnSe oder SiC basierende Verbindung handelt.

13. Beleuchtungseinheit nach Anspruch 11, **dadurch gekennzeichnet, dass** es sich bei der Lichtquelle um eine organisch lichtemittierende Anordnung oder um eine Plasma- oder Entladungslampe handelt.

14. Beleuchtungseinheit nach einem oder mehreren der Ansprüche 11 bis 13,
**dadurch gekennzeichnet, dass** der Leuchtstoff direkt auf der Primärlichtquelle und/oder von dieser entfernt angeordnet ist.

15. Beleuchtungseinheit nach einem oder mehreren der Ansprüche 11 bis 14,
**dadurch gekennzeichnet, dass** die optische Ankopplung zwischen dem Leuchtstoff und der Primärlichtquelle durch eine lichtleitende Anordnung realisiert ist.

16. Verwendung von mindestens einer Verbindung nach einem oder mehreren der Ansprüche 1 bis 4 als Leuchtstoff oder Konversionsleuchtstoff zur teilweisen oder vollständigen Konversion der blauen oder im UV-liegenden Emission einer Lumineszenzdiode oder als Konversionsleuchtstoff zur Konversion der Primärstrahlung in einen bestimmten Farbpunkt nach dem Color-on-demand-Konzept.

17. Verwendung eines Formkörpers nach einem oder mehreren der Ansprüche 6 bis 9 als Leuchtstoffkörper.

## Claims

1. Compound of the M₂Si₅N₈:Eu²⁺ type with optional cerium doping, where M stands for an alkaline-earth metal or a mixture of a plurality of alkaline-earth metals which additionally contains at least one co-dopant selected from the group consisting of hafnium, zirconium, lithium, sodium and potassium, where at least one co-dopant is selected from the group consisting of hafnium and zirconium.

2. Compound according to Claim 1, **characterised by** the formula I
Ma_{2-y} (Ca,Sr,Ba)_{1-x-y}Si_{5-z}Me_{z}N₈:EuₓCe_{y} (I)
where
Ma = Li, Na and/or K
Me = Hf⁴⁺ and/or Zr⁴⁺
x = 0.0015 to 0.20 and
y=0 to 0.15
z<4.

3. Compound according to Claim 1 and/or 2, **characterised in that** z < 1, preferably z < 0.1, more preferably z = 0.0002 to 0.02.

4. Compound according to one or more of Claims 1 to 3, obtainable by mixing silicon nitride-, europium-, cerium- and calcium- and/or strontium- and/or barium-containing starting materials with at least one co-dopant selected from the group consisting of hafnium-, zirconium-, lithium-, sodium- and potassium-containing co-dopants by solid-state diffusion methods with subsequent thermal aftertreatment.

5. Process for the preparation of a compound according to one or more of Claims 1 to 4 having the following process steps:
a) preparation of a europium- and/or cerium-doped 2-5-8 alkaline-earth metal siliconitride compound which is co-doped with at least one material selected from the group consisting of hafnium-, zirconium-, lithium-, sodium- and potassium-containing materials, by mixing at least 4 starting materials selected from silicon nitride-, europium-, cerium-, calcium-, strontium-, barium-, hafnium-, zirconium-, lithium-, sodium- and/or potassium-containing materials,
b) thermal aftertreatment of the co-doped compound.

6. Shaped body comprising a compound according to one or more of Claims 1 to 4, **characterised in that** it has a rough surface which carries nanoparticles selected from the group consisting of SiO₂, TiO₂, Al₂O₃, ZnO, ZrO₂ and Y₂O₃ and mixed oxides thereof and/or particles comprising the compound according to one or more of Claims 1 to 4 with or without dopants selected from the group consisting of europium, cerium, hafnium, zirconium, lithium, sodium and potassium.

7. Shaped body comprising a compound according to one or more of Claims 1 to 4, **characterised in that** it has a closed surface coating selected from the group consisting of SiO₂, TiO₂, Al₂O₃, ZnO, ZrO₂ and Y₂O₃ or mixed oxides thereof and/or of the compound according to one or more of Claims 1 to 4 without the activator europium.

8. Shaped body comprising a compound according to one or more of Claims 1 to 4, **characterised in that** it has a porous surface coating selected from the group consisting of SiO₂, TiO₂, Al₂O₃, ZnO, ZrO₂ and Y₂O₃ or mixed oxides thereof and/or of the compound according to one or more of Claims 1 to 4 with or without dopants selected from the group consisting of europium, cerium, hafnium, zirconium, lithium, sodium and potassium.

9. Shaped body comprising a compound according to one or more of Claims 1 to 4, **characterised in that** the surface carries functional groups which facilitate chemical or physical bonding to the environment, preferably consisting of epoxy or silicone resin.

10. Process for the production of a shaped body according to one or more of Claims 6 to 9 having the following process steps:
a) preparation of a 2-5-8 europium-doped alkaline-earth metal siliconitride compound which is co-doped with hafnium- and/or zirconium-containing materials by mixing at least 4 starting materials selected from the group consisting of silicon nitride-, europium-, cerium-, calcium-, strontium-, barium-, hafnium-, zirconium-, lithium-, sodium- and potassium-containing materials,
b) thermal aftertreatment of the co-doped compound and formation of a shaped body having a rough surface,
c) coating of the rough surface with nanoparticles selected from the group consisting of SiO₂, TiO₂, Al₂O₃, ZnO, ZrO₂ and/or Y₂O₃ or mixed oxides thereof or with nanoparticles comprising the compound according to one or more of Claims 1 to 4 with or without dopants.

11. Lighting unit having at least one primary light source whose emission maximum is in the range 250 nm to 530 nm, preferably between 390 nm and 480 nm, where this radiation is partially or completely converted into longer-wave radiation by a compound or shaped body according to one or more of Claims 1 to 10.

12. Lighting unit according to Claim 11, **characterised in that** the light source is a luminescent indium aluminium gallium nitride, in particular of the formula InᵢGaⱼAlₖN, where 0≤i, 0≤j, 0≤k and i+j+k=1, or a luminescent compound based on ZnO, TCO (transparent conducting oxide), ZnSe or SiC.

13. Lighting unit according to Claim 11, **characterised in that** the light source is an organic light-emitting arrangement or a plasma or discharge lamp.

14. Lighting unit according to one or more of Claims 11 to 13, **characterised in that** the phosphor is arranged directly on the primary light source and/or remote therefrom.

15. Lighting unit according to one or more of Claims 11 to 14, **characterised in that** the optical coupling between the phosphor and the primary light source is achieved by a light-conducting arrangement.

16. Use of at least one compound according to one or more of Claims 1 to 4 as phosphor or conversion phosphor for partial or complete conversion of the blue or UV emission from a luminescent diode or as conversion phosphor for conversion of the primary radiation into a certain colour point in accordance with the colour-on-demand concept.

17. Use of a shaped body according to one or more of Claims 6 to 9 as phosphor element.

## Revendications

1. Composé de type M₂Si₅N₈:Eu²⁺ ayant un dopage facultatif au cérium, dans lequel M représente un métal alcalino-terreux ou un mélange d'une pluralité de métaux alcalino-terreux qui contient en outre au moins un co-dopant choisi dans le groupe constitué par l'hafnium, le zirconium, le lithium, le sodium et le potassium, où au moins un co-dopant est choisi dans le groupe constitué par l'hafnium et le zirconium.

2. Composé selon la revendication 1, **caractérisé par** la formule I
Ma_{2y} (Ca,Sr,Ba)_{1-x-y}Si_{5-z}Me_{z}N₈:EuₓCe_{y} (I)
dans laquelle
Ma = Li, Na et/ou K
Me = Hf⁴⁺ et/ou Zr⁴⁺
x = 0,0015 à 0,20 et
y=0 à 0,15
z<4.

3. Composé selon la revendication 1 et/ou 2, **caractérisé en ce que** z < 1, préférablement z < 0,1, plus préférablement z = 0,0002 à 0,02.

4. Composé selon l'une ou plusieurs parmi les revendications 1 à 3, pouvant être obtenu par le mélange de matériaux de départ à base de nitrure de silicium, d'europium, de cérium et de calcium et/ou de strontium et/ou de baryum avec au moins un co-dopant choisi dans le groupe constitué par les co-dopants à base d'hafnium, de zirconium, de lithium, de sodium et de potassium par des méthodes de diffusion à l'état solide avec un post-traitement thermique ultérieur.

5. Procédé de préparation d'un composé selon l'une ou plusieurs parmi les revendications 1 à 4, présentant les étapes de procédé suivantes :
a) la préparation d'un composé à base de nitrure de silicium de 2-5-8 métaux alcalino-terreux dopé à l'europium et/ou au cérium qui est co-dopé par au moins un matériau choisi dans le groupe constitué par des matériaux à base d'hafnium, de zirconium, de lithium, de sodium et de potassium, en mélangeant au moins 4 matériaux de départ choisis parmi des matériaux à base de nitrure de silicium, d'europium, de cérium, de calcium, de strontium, de baryum, d'hafnium, de zirconium, de lithium, de sodium et/ou de potassium,
b) le post-traitement thermique du composé co-dopé.

6. Corps profilé comprenant un composé selon l'une ou plusieurs parmi les revendications 1 à 4, **caractérisé en ce qu'**il possède une surface rugueuse qui porte des nanoparticules choisies dans le groupe constitué par SiO₂, TiO₂, Al₂O₃, ZnO, ZrO₂ et Y₂O₃ et des oxydes mixtes de ceux-ci et/ou des particules comprenant le composé selon l'une ou plusieurs parmi les revendications 1 à 4 avec ou sans dopants choisis dans le groupe constitué par l'europium, le cérium, l'hafnium, le zirconium, le lithium, le sodium et le potassium.

7. Corps profilé comprenant un composé selon l'une ou plusieurs parmi les revendications 1 à 4, **caractérisé en ce qu'**il possède un revêtement de surface fermé choisi dans le groupe constitué par SiO₂, TiO₂, Al₂O₃, ZnO, ZrO₂ et Y₂O₃ ou des oxydes mixtes de ceux-ci et/ou du composé selon l'une ou plusieurs parmi les revendications 1 à 4 sans l'activateur d'europium.

8. Corps profilé comprenant un composé selon l'une ou plusieurs parmi les revendications 1 à 4, **caractérisé en ce qu'**il possède un revêtement de surface poreux choisi dans le groupe constitué par SiO₂, TiO₂, Al₂O₃, ZnO, ZrO₂ et Y₂O₃ ou des oxydes mixtes de ceux-ci et/ou du composé selon l'une ou plusieurs parmi les revendications 1 à 4 avec ou sans dopants choisis dans le groupe constitué par l'europium, le cérium, l'hafnium, le zirconium, le lithium, le sodium et le potassium.

9. Corps profilé comprenant un composé selon l'une ou plusieurs parmi les revendications 1 à 4, **caractérisé en ce que** la surface porte des groupements fonctionnels qui facilitent une liaison chimique ou physique à l'environnement, préférablement constitué de résine époxy ou silicone.

10. Procédé de production d'un corps profilé selon l'une ou plusieurs parmi les revendications 6 à 9, présentant les étapes de procédé suivantes :
a) la préparation d'un composé à base de nitrure de silicium de 2-5-8 métaux alcalino-terreux dopé à l'europium qui est co-dopé par des matériaux à base d'hafnium et/ou de zirconium en mélangeant au moins 4 matériaux de départ choisis dans le groupe constitué par des matériaux à base de nitrure de silicium, d'europium, de cérium, de calcium, de strontium, de baryum, d'hafnium, de zirconium, de lithium, de sodium et de potassium,
b) le post-traitement thermique du composé co-dopé et la formation d'un corps profilé ayant une surface rugueuse,
c) le revêtement de la surface rugueuse par des nanoparticules choisies dans le groupe constitué par SiO₂, TiO₂, Al₂O₃, ZnO, ZrO₂ et/ou Y₂O₃ ou des oxydes mixtes de ceux-ci ou par des nanoparticules comprenant le composé selon l'une ou plusieurs parmi les revendications 1 à 4 avec ou sans dopants.

11. Bloc d'éclairage ayant au moins une source lumineuse primaire dont le maximum d'émission se trouve dans la plage allant de 250 nm à 530 nm, préférablement entre 390 nm et 480 nm, où ce rayonnement est partiellement ou complètement converti en rayonnement d'onde plus longue par un composé ou un corps profilé selon l'une ou plusieurs parmi les revendications 1 à 10.

12. Bloc d'éclairage selon la revendication 11, **caractérisé en ce que** la source lumineuse est un nitrure d'indium aluminium gallium luminescent, en particulier de formule InᵢGaⱼAlₖN, où 0 ≤ i, 0 ≤ j, 0 ≤ k et i+j+k=1, ou un composé luminescent à base de ZnO, TCO (oxyde conducteur transparent), ZnSe ou SiC.

13. Bloc d'éclairage selon la revendication 11, **caractérisé en ce que** la source lumineuse est un arrangement organique photoémetteur ou un plasma ou une lampe à décharge.

14. Bloc d'éclairage selon l'une ou plusieurs parmi les revendications 11 à 13, **caractérisé en ce que** le luminophore est disposé directement sur la source lumineuse primaire et/ou en est éloigné.

15. Bloc d'éclairage selon l'une ou plusieurs parmi les revendications 11 à 14, **caractérisé en ce que** le couplage optique entre le luminophore et la source lumineuse primaire est obtenu par un arrangement photoconducteur.

16. Utilisation d'au moins un composé selon l'une ou plusieurs parmi les revendications 1 à 4, comme luminophore ou luminophore de conversion pour la conversion partielle ou complète de l'émission de bleu ou d'UV à partir d'une diode luminescente ou comme luminophore de conversion pour la conversion du rayonnement primaire en un certain point de couleur conformément au concept de couleur à la demande.

17. Utilisation d'un corps profilé selon l'une ou plusieurs parmi les revendications 6 à 9, comme élément de luminophore.
